# FASCICULE DE BREVET EUROPEEN

(11) **EP 1 376 417 B1**
(45) Date de publication et mention de la délivrance du brevet: **07.09.2016**
(21) Numéro de dépôt: 03291452.5
(22) Date de dépôt: 16.06.2003
(51) Int. Cl.: G06F 11/26, G01R 31/3183, G06F 17/50

(54) **Procédé et système d'émulation d'un circuit sous test associé à un environnement de test**
Verfahren und System zur Emulation einer mit einer Testumgebung verbundenen Schaltung im Test
Method and system for emulating a circuit under test associated with a test environment

(30) Priorité: 26.06.2002 FR 0207949
(43) Date de publication de la demande: 02.01.2004
(73) Titulaire: SYNOPSYS EMULATION AND VERIFICATION, 91320 Wissous (FR)
(72) Inventeur: Bergun, Luc, 94370 Sucy en Brie (FR); Reynier, David, 91400 Orsay (FR); Delerse, Sébastien, 91380 Chilly-Mazarin (FR); Emirian, Frédéric, 91380 Chilly-Mazarin (FR); Douezy, François, 78300 Poissy (FR)
(74) Mandataire: Dossmann, Gérard

(56) Documents cités:
- US-B1- 6 347 388
- NEALE R: "Verisity's eCelerator offers test bench synthesis" ELECTRONIC ENGINEERING DESIGN, APRIL 2002, CMP ELECTRONICS GROUP, UK, vol. 74, no. 903, pages 27-28, XP008016066 ISSN: 0013-4902
- HUTCHINGS B L ET AL: "Unifying simulation and execution in a design environment for FPGA systems" IEEE TRANS. VERY LARGE SCALE INTEGR. (VLSI) SYST. (USA), IEEE TRANSACTIONS ON VERY LARGE SCALE INTEGRATION (VLSI) SYSTEMS, FEB. 2001, IEEE, USA, vol. 9, no. 1, pages 201-205, XP002239439 ISSN: 1063-8210
- HAKKARAINEN H ET AL: "VHDL macro library testing using BOAR emulation tool", ASIC CONFERENCE AND EXHIBIT, 1995., PROCEEDINGS OF THE EIGHTH ANNUAL I EEE INTERNATIONAL AUSTIN, TX, USA 18-22 SEPT. 1995, NEW YORK, NY, USA,IEEE, US, 18 September 1995 (1995-09-18), pages 105-108, XP010217982, DOI: 10.1109/ASIC.1995.580692 ISBN: 978-0-7803-2707-8
- ISOAHO J ET AL: "BOAR: an advanced HW/SW coemulation environment for DSP system development", MICROPROCESSORS AND MICROSYSTEMS, IPC BUSINESS PRESS LTD. LONDON, GB, vol. 20, no. 10, 1 June 1997 (1997-06-01), pages 607-615, XP004085533, ISSN: 0141-9331, DOI: 10.1016/S0141-9331(97)00003-3

## Description

L'invention concerne le domaine de la conception électronique assistée par ordinateur (CAO électronique) et plus particulièrement celui de la vérification fonctionnelle de circuits intégrés et plus généralement de systèmes électroniques.

L'invention s'applique notamment à la mise en oeuvre d'un environnement de test d'un circuit dont on cherche à valider le fonctionnement (et appelé « circuit sous test ») et qui est émulé entièrement ou pour partie par un système matériel reconfigurable.

Ces systèmes matériels reconfigurables englobent généralement à la fois les systèmes d'émulation (ou « émulateurs ») et les systèmes de prototypage. Par la suite, on utilisera le terme « émulateur » pour désigner un « système matériel reconfigurable », et donc on inclura sous ce vocable les systèmes de prototypages.

Les systèmes matériels reconfigurables sont constitués d'une ou de plusieurs cartes sur lesquelles on retrouve des circuits reconfigurables de type FPGA (Field Programmable Gate Array) ou des circuits reconfigurables à façon (custom), et qui sont connectés entre eux selon des moyens fixes ou reconfigurables. Les cartes constituant le système matériel reconfigurable peuvent être enfichées dans un ou plusieurs racks. Une interface assure la communication du système matériel reconfigurable avec un ordinateur de contrôle (ou ordinateur hôte). Historiquement, les premiers systèmes matériels reconfigurables de ce type étaient réduits à leur plus simple expression, c'est-à-dire un seul circuit reconfigurable monté sur une carte et qui proposait un seul mode de validation, à savoir l'émulation in-circuit.

Dans ce cas, l'environnement de test du circuit est constitué du système cible devant à terme recevoir le circuit sous test, de câbles et de connecteurs permettant au système cible de communiquer avec le circuit reconfigurable placé sur un autre circuit imprimé. Les circuits reconfigurables étant en général plus lents que les circuits à façon que l'on cherche à réaliser et à valider, il pouvait être nécessaire de ralentir la vitesse du système cible pour que le circuit reconfigurable fonctionne correctement.

Les systèmes matériels reconfigurables ont ensuite évolué pour proposer à la fois plus de capacité et plus de fonctionnalité. Au niveau des fonctionnalités, plusieurs alternatives d'environnement de test ont ainsi été proposées :
- environnement de test à base de vecteurs de test embarqués dans le système reconfigurable : les vecteurs de test peuvent être stockés dans une ou plusieurs mémoires du système reconfigurable et un comparateur logique est mis en oeuvre pour comparer les sorties du circuit sous test avec les sorties attendues,
- environnement de test constitué d'un modèle matériel synthétisable embarqué dans le système reconfigurable : l'environnement de test peut être décrit par un modèle matériel que l'on peut émuler et donc implanter directement dans le système reconfigurable,
- environnement de test constitué d'un modèle matériel simulé sur l'ordinateur hôte : l'environnement de test peut être décrit par un modèle matériel que l'on va simuler (il n'est pas synthétisable) sur l'ordinateur hôte. Un lien entre l'ordinateur hôte et le système reconfigurable permet d'assurer la communication entre l'environnement de test simulé et le circuit sous test émulé.

Chaque environnement de test présente des caractéristiques différentes au niveau de la performance, de la facilité de mise en oeuvre et de la souplesse d'utilisation. Du point de vue des performances, une règle générale veut que le gain est maximal vis-à-vis d'une simulation par logiciel lorsque l'environnement de test est réalisé directement par du matériel. Ce matériel peut être le système cible (mode d'émulation in-circuit) ou une implantation de l'environnement de test par le système matériel reconfigurable (stimulation à base de vecteurs de test ou modèle matériel de stimulation embarquée). Néanmoins, cette approche n'est pas toujours envisageable, en particulier parce que la description d'un modèle matériel d'un environnement de test peut s'avérer très difficile à réaliser et à maintenir. Les concepteurs de circuit préfèrent souvent modéliser leur environnement de test à un niveau d'abstraction à la fois plus élevé et différent de celui utilisé pour décrire leur circuit sous test.

Une tendance actuelle consiste à vouloir stimuler le circuit sous test par du logiciel en recherchant un gain de performance similaire à celui obtenu par un système reconfigurable dans un mode où il est stimulé uniquement par matériel. Cette approche est particulièrement intéressante lorsque le système cible n'a pas encore été finalisé, lorsque l'environnement de test est susceptible de changer de façon importante pendant la validation du circuit sous test ou enfin lorsque l'on recherche à déboger le circuit sous test à un niveau d'abstraction plus élevé.

Récemment, un consortium (appelé "Standard Co-Emulation API Consortium) a été créé dont l'objectif est de définir une interface normalisée pour des systèmes matériels reconfigurables permettant de valider un circuit sous test à partir d'un programme écrit en langage C ou en langage C++. Cette interface fournit plusieurs canaux de communication qui permettent à des modèles logiciels de l'environnement de test de communiquer avec le circuit sous test émulé.

Cette interface a été plus particulièrement définie pour supporter un type de communication entre un modèle logiciel et le circuit sous test appelé transactionnel. Une transaction peut être définie comme une séquence spécifique de transition sur un ensemble de signaux pendant une période donnée.

Dans ce mode de stimulation et d'observation, plusieurs blocs matériels sont ajoutés à la périphérie du circuit sous test pour traduire les données transactionnelles provenant du modèle logiciel en données de type bit/signal compatibles avec l'interface réelle du circuit sous test et vice-versa. Ces blocs matériels, appelés aussi transacteurs sont réalisés par le système matériel reconfigurable.

Ce mode se traduit par une augmentation importante de la logique utilisée dans le système matériel reconfigurable pour réaliser tout ou partie de l'environnement de test. Ces besoins en ressources logiques supplémentaires sont aussi accompagnés par des besoins accrus en performance. Les blocs matériels assurant la traduction de données au niveau transactionnel vers le niveau bit/signal peuvent ainsi devenir le goulot d'étranglement au niveau des performances puisqu'ils peuvent intégrer des mécanismes complexes de traduction nécessitant plusieurs cycles d'horloge.

Il est donc nécessaire de prendre en compte les caractéristiques de ces nouveaux environnements de test dans la définition des futures architectures de système matériel reconfigurable, ceci incluant à la fois les systèmes d'émulation et les systèmes de prototypage.

Le document "VHDL macro library testing using BOAR emulation tool" par H. Hakkarainen décrit un procédé d'émulation sous test utilisant deux parties matérielles reconfigurables mutuellement connectées.

Actuellement, la partie de l'environnement de test qui est embarquée dans le système matériel reconfigurable et le circuit sous test sont tous les deux implantés par les mêmes ressources configurables. Il en résulte par conséquent une très forte dépendance entre l'environnement de test et le circuit sous test. De ce fait, une modification dans l'environnement de test (par exemple un transacteur) pourra entraîner une recompilation du circuit sous test alors que celui-ci n'a pas changé. Inversement, une modification dans le circuit sous test pourra impliquer une recompilation de l'environnement de test alors que celui-ci n'a pas changé.

Par ailleurs, actuellement, le matériel utilisé est du matériel générique qui n'est pas forcément adapté pour l'implantation d'un environnement de test, que ce soit en termes de vitesse ou de densité. En effet, la structure d'un environnement de test est très spécifique. Certains de ces blocs doivent fonctionner à des fréquences importantes difficiles à obtenir et à garantir avec un système matériel reconfigurable générique. L'émulation de la partie matérielle de l'environnement de test par un émulateur générique peut finalement avoir un impact négatif sur les performances globales du système d'émulation.

La généricité des systèmes matériels reconfigurables se traduit donc par une sous-utilisation des ressources matérielles, un manque de performance et des temps de compilation plus longs.

De plus, les systèmes matériels reconfigurables actuels sont très limités en ce qui concerne leur capacité à mélanger plusieurs modes de stimulation. Il est ainsi impossible de mettre en oeuvre des environnements de test hétérogènes incluant différents types de modélisation, différents niveaux de communication, voire différents moyens de simulation.

Par ailleurs, l'évolution des circuits reconfigurables va vers une intégration de plus en plus poussée de sorte qu'un seul circuit reconfigurable pourra être suffisant pour émuler un circuit de taille importante (de l'ordre du million de portes) dans un avenir très proche. Un tel circuit reconfigurable pourra en effet couvrir les besoins des concepteurs de blocs de propriété intellectuelle, de circuits spécifiques (ASIC), et par définition de circuits implantés sur circuits reconfigurables (FPGA). En définissant un système matériel reconfigurable basé sur un seul circuit reconfigurable, on s'affranchit des problèmes très complexes inhérents à la compilation pour des systèmes avec plusieurs circuits reconfigurables, tels que le partitionnement, la gestion des bus et des horloges. Le système peut alors s'appuyer directement sur la chaîne de compilation du fournisseur de circuit reconfigurable, ce qui limite les efforts de développement et offre une solution standard facile à déployer et à supporter.

L'invention vise à apporter une solution à ces problèmes.

L'invention a pour but de définir une nouvelle architecture de plate-forme de simulation/émulation tenant compte de l'évolution de la complexité des environnements de test, des besoins en performance et de l'évolution de la technologie des circuits reconfigurables.

L'invention a pour but de permettre la description d'environnements de test mixtes (matériel et logiciel) très complexes tout en offrant des performances et une intégration en adéquation avec la demande du marché.

La plate-forme de simulation/émulation selon l'invention est ainsi basée sur une approche où l'on sépare le système reconfigurable émulant le circuit sous test, de celui émulant la partie matérielle de son environnement de test. Cette approche s'applique particulièrement bien au cas où le système matériel reconfigurable émulant le circuit sous test est basé sur un seul circuit reconfigurable, mais elle peut être facilement étendue aux cas de systèmes matériels reconfigurables plus complexes.

L'invention propose donc un procédé d'émulation d'un circuit comme décrit dans la revendication 1, ce procédé comportant
- deux phases distinctes de génération comportant une première phase de génération d'un premier fichier de configuration de l'environnement de test, et une deuxième phase de génération d'un deuxième fichier de configuration d'au moins une partie du circuit sous test,
- la délivrance du premier fichier de configuration à une première partie matérielle reconfigurable formant un banc de test reconfigurable de façon à configurer le banc de test, et
- la délivrance du deuxième fichier de configuration à une deuxième partie matérielle reconfigurable de façon à configurer un émulateur du circuit sous test, les deux parties matérielles étant distinctes et mutuellement connectées, et
- l'utilisation d'un banc de test reconfigurable délivrant différents signaux d'horloge secondaires synchronisant l'émulateur et le banc de test.

Ainsi, chaque partie matérielle peut être par exemple réalisée au moyen d'un circuit reconfigurable du type FPGA.

La première phase de génération et la deuxième phase de génération peuvent être effectuées en parallèle ou bien séquentiellement et, dans ce dernier cas, l'ordre importe peu. En effet, on peut effectuer la première phase de génération avant ou après la deuxième phase de génération.

Selon un mode de mise en oeuvre de l'invention, la première phase de génération comporte la production d'un circuit logique constitué d'un réseau de portes logiques représentatives de l'environnement de test ainsi que des directives de compilation. La première phase de génération comporte également une compilation de ce circuit logique compte tenu desdites directives, de façon à obtenir le premier fichier de configuration.

Selon un mode de mise en oeuvre, l'environnement de test comporte un ensemble de pilotes et de moniteurs. La production dudit circuit logique comporte alors la formation de blocs matériels sous la forme de réseau de portes logiques, ces blocs matériels représentant des interfaces de pilotes/moniteurs de stimulation logicielle, des interfaces de pilotes/moniteurs de stimulation matérielle et des pilotes/moniteurs de stimulation matérielle émulée. La production du circuit logique comporte également la formation d'un bloc d'interface permettant aux blocs matériels cités précédemment de communiquer avec l'émulateur du circuit sous test.

Lorsque la première phase de génération (génération du fichier de configuration du banc de test) est effectuée après la deuxième phase de génération (configuration de l'émulateur), la production du circuit logique utilise comme paramètre d'entrée une description de l'assignation des entrées et sorties logiques du circuit sous test aux broches de l'émulateur.

Par contre, lorsque la deuxième phase de génération est effectuée après la première phase de génération, la production du circuit logique utilise comme paramètre d'entrée une description de l'interface du circuit sous test et fournit en sortie une description de l'assignation des entrées/sorties logiques du circuit sous test aux broches de l'émulateur, cette description de sortie étant alors un paramètre de contrainte pour la deuxième phase de génération.

En d'autres termes, produire la configuration du banc de test reconfigurable avant l'émulateur impose plus de contraintes au compilateur du circuit sous test, mais est plus simple pour l'utilisateur.

Par contre, débuter par la génération de la configuration de l'émulateur du circuit sous test offre plus de densité puisque la compilation du circuit sous test n'est pas contrainte par une assignation a priori de ses entrées-sorties aux broches de l'émulateur qui le réalise.

A partir du moment où une première génération a été faite pour la configuration du circuit sous test et celle du banc de test reconfigurable, il est avantageux de ré-utiliser l'assignation des entrées-sorties ainsi déterminée pour les générations suivantes, ce qui évite la re-compilation de l'environnement de test lorsque seul le circuit sous test a changé et vice-versa.

L'invention a également pour objet un système d'émulation, destiné à émuler un circuit sous test associé à un environnement de test.

Selon une caractéristique générale de l'invention, le système comporte un banc de test matériel reconfigurable capable d'émuler une partie au moins de l'environnement de test, ce banc de test étant connecté entre un ordinateur hôte et un émulateur matériel reconfigurable distinct du banc de test et capable d'émuler au moins une partie du circuit sous test.

Le système comporte par ailleurs des premiers moyens de génération aptes à générer un premier fichier de configuration de l'environnement de test, et des deuxièmes moyens de génération aptes à générer un deuxième fichier de configuration d'au moins une partie du circuit sous test.

Selon un mode de réalisation de l'invention, le banc de test reconfigurable comporte une partie dite fixe et au moins un circuit reconfigurable capable de réaliser la partie émulée de l'environnement de test.

Au sens de l'invention, une partie fixe s'entend comme étant une partie ne variant pas en fonction de l'environnement de test par opposition à une partie reconfigurable qui est configurée au cas par cas en fonction de l'environnement de test. Ainsi, la partie fixe pourrait être réalisée par des circuits figés (non reconfigurables), ou éventuellement par des circuits reconfigurables mais à circuiterie fixe.

Selon un mode de réalisation de l'invention, la partie fixe comporte au moins un circuit de contrôle et un circuit d'interface avec l'ordinateur hôte. Le circuit reconfigurable réalisant la partie émulée de l'environnement de test est par ailleurs apte à comporter au moins des interfaces de pilotes/moniteurs de stimulation logicielle capables d'établir une communication avec au moins un processus logiciel exécuté sur ordinateur hôte, ainsi que des pilotes/moniteurs de stimulation matérielle émulée.

La partie fixe peut comporter en outre des pilotes/moniteurs matériels réels supplémentaires. Le circuit reconfigurable réalisant la partie émulée de l'environnement de test est alors apte à comporter en outre des interfaces avec ces pilotes/moniteurs matériels réels supplémentaires.

La partie fixe peut également comporter en outre un circuit d'interface avec un dispositif cible, de façon à pouvoir réaliser une émulation in-circuit.

La partie fixe peut aussi venir sous la forme d'un seul circuit qui intègre alors le circuit de contrôle, le circuit d'interface avec l'ordinateur hôte et le circuit d'interface avec le dispositif cible.

A noter aussi que le circuit d'interface avec le dispositif cible peut aussi être réalisé dans le ou les circuits reconfigurables réalisant la partie émulée de l'environnement de test, ce qui permet de limiter le nombre de circuit à traverser pour faire communiquer le circuit sous test avec son dispositif cible.

Le banc de test et l'émulateur peuvent être réalisés sur une carte électronique externe à l'ordinateur hôte et connecté à la carte mère de celui-ci à travers une carte d'interface.

En variante, le banc de test peut être réalisé sur une première carte électronique externe à l'ordinateur hôte et connectée à la carte mère de celui-ci à travers une carte d'interface tandis que l'émulateur peut être réalisé sur une ou plusieurs autres cartes externes à l'ordinateur hôte connecté sur ladite première carte externe.

En variante, le banc de test et l'émulateur peuvent être réalisés sur une carte électronique interne incorporée dans l'ordinateur hôte.

Dans ce cas, le circuit d'interface avec un éventuel dispositif cible peut être réalisé sur une carte électronique externe à l'ordinateur hôte et apte à être connecté sur ladite carte électronique interne.

L'invention a également pour objet une carte électronique, destinée à être connectée à la carte mère d'un ordinateur hôte, comportant un banc de test matériel reconfigurable capable d'émuler une partie au moins d'un environnement de test associé à un circuit sous test, et un émulateur matériel reconfigurable distinct du banc de test, connecté au banc de test reconfigurable et capable d'émuler au moins une partie du circuit sous test.

Le banc de test reconfigurable peut comporter une partie dite fixe et au moins un circuit reconfigurable capable de réaliser la partie émulée de l'environnement de test.

D'autres avantages et caractéristiques de l'invention apparaîtront à l'examen de la description détaillée de mode de mise en oeuvre et de réalisation, nullement limitative, et des dessins annexés sur lesquels :
- la figure 1 illustre schématiquement un mode de réalisation d'un système d'émulation selon l'invention,
- la figure 2 illustre un mode de réalisation du système d'émulation selon l'invention lorsque le banc de test reconfigurable et l'émulateur sont intégrés dans l'ordinateur hôte,
- la figure 3 illustre plus en détail, mais toujours de façon schématique, une architecture générale d'un banc de test reconfigurable selon l'invention,
- la figure 4 illustre plus en détail une partie de la figure 3,
- la figure 5 illustre schématiquement un mode de réalisation d'un circuit de contrôle d'un banc de test reconfigurable
- la figure 6 illustre schématiquement un exemple d'environnement de test pour un circuit sous test,
- la figure 7a illustre schématiquement une autre représentation d'un banc de test reconfigurable selon l'invention,
- la figure 7b illustre schématiquement un mode de réalisation d'un circuit reconfigurable d'interface d'un banc de test reconfigurable
- la figure 8 représente schématiquement un mode de mise en oeuvre d'un procédé d'émulation selon l'invention,
- la figure 9a illustre plus en détail un flot général de génération de la configuration d'un banc de test reconfigurable dans le cas où le circuit sous test a déjà été compilé sur son émulateur,
- La figure 9b illustre plus en détail un flot général de génération de la configuration d'un banc de test reconfigurable dans le cas où le circuit sous test n'a pas encore été compilé sur son émulateur,
- les figures 10 et 11 illustrent une représentation de modules pilotes,
- la figure 12a illustre schématiquement un mode de réalisation de moyens de rétrocontrôle d'horloge selon l'invention, et
- La figure 12b illustre sous la forme d'une table le comportement de la circuiterie de retro-contrôle mise en oeuvre pour la figure 12a.

Un circuit sous test peut être modélisé par une description comportementale à différents niveaux d'abstraction. Le comportement du circuit peut ainsi être décrit par un modèle logiciel (par exemple un programme C ou C++) et/ou un modèle matériel exprimé au niveau comportemental, transfert de registres (RTL) ou encore comme un réseau de portes. Un modèle matériel peut être simulé par un logiciel spécialisé appelé simulateur de description matérielle ou bien il peut être émulé par un système matériel reconfigurable. Dans le second cas, le modèle émulé correspond directement à une réalisation matérielle.

L'invention concerne des circuits sous test dont au moins une partie ou la totalité de la description est émulée par un système matériel reconfigurable.

Dans la suite du texte, on s'intéressera uniquement au cas où le circuit sous test est complètement émulé par un système matériel reconfigurable, même s'il est évident que cette invention peut être facilement appliquée au cas où seule une partie du circuit sous test est émulée par un système matériel reconfigurable, l'autre partie pouvant venir sous la forme d'un modèle logiciel, exécuté (par exemple un simulateur de processeur au niveau jeu d'instruction), ou un modèle matériel simulé. On considérera alors que la partie émulée devient le circuit sous test et que l'autre partie devient son environnement de test.

En ce qui concerne l'environnement de test, celui-ci peut être défini comme représentant tous les moyens mis en oeuvre par le concepteur de circuits intégrés pour valider son circuit. Les entrées/sorties du circuit sous test sont stimulées et observées par l'environnement de test. La stimulation peut être produite d'une façon aléatoire ou en tenant compte des caractéristiques structurelles et fonctionnelles du circuit sous test. L'observation intègre en général une analyse de la réponse du circuit sous test avec éventuellement une comparaison avec la réponse attendue. Cette réponse attendue est déterminée en fonction des spécifications de base du circuit à tester.

Comme le circuit sous test, l'environnement de test peut être défini à travers un ensemble logiciel/matériel complexe. Il peut ainsi être défini par une combinaison de modèles logiciels et/ou matériels. Ces modèles viennent stimuler et observer le circuit sous test et on les appellera par la suite des pilotes/moniteurs. Les modèles matériels de l'environnement de test peuvent aussi être simulés ou émulés. Ceci étant, une partie de l'environnement de test peut aussi être réalisée par du véritable matériel.

Un système matériel reconfigurable peut correspondre à un seul circuit reconfigurable ou à n'importe quel arrangement de circuits reconfigurables. Un circuit reconfigurable peut être de type FPGA, tels que ceux commercialisés par les sociétés XILINX ou ALTERA, ou un circuit à façon (custom) ayant des propriétés de reconfigurabilité.

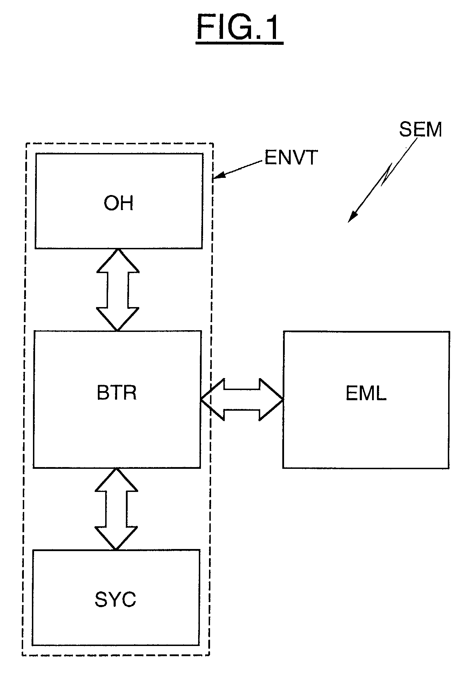

Sur la figure 1, la référence SEM désigne un système d'émulation selon l'invention.

Ce système inclut un émulateur du circuit sous test EML et un ensemble ENVT réalisé en environnement de test pour ce même circuit sous test. Un banc de test reconfigurable BTR constitue la pièce centrale de l'environnement de test. Il permet à l'émulateur du circuit sous test de communiquer avec un ordinateur hôte OH (qu'il s'agisse d'un ordinateur personnel, d'une station de travail ou d'un serveur) et avec un éventuel dispositif (ou système) cible qui doit recevoir le circuit sous test (dans le cas d'une émulation in-circuit).

Le banc de test reconfigurable BTR communique avec l'ordinateur hôte OH à travers un bus rapide tel qu'un bus PCI, AGP ou une interface rapide tels que éthernet, SCSI.

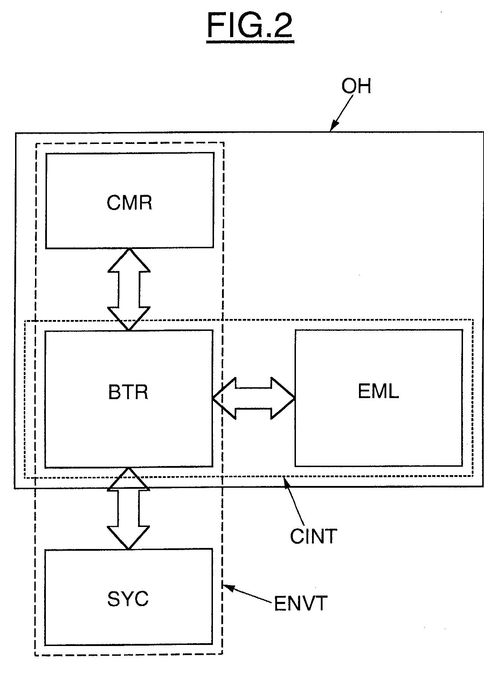

Sur la figure 2, le banc de test reconfigurable BTR et l'émulateur EML sont disposés sur une carte électronique interne CINT incorporée à l'ordinateur hôte et connectée à la carte mère CMR de cet ordinateur hôte. Une telle carte interne peut être une carte PCI au format standard, ou une carte AGP. L'intégration du banc de test reconfigurable et de l'émulateur d'un ordinateur hôte permet d'obtenir de meilleures performances pour la communication entre l'émulateur et l'unité centrale de l'ordinateur. Ceci est d'autant plus intéressant lorsque l'environnement de test est exécuté, interprété ou simulé sur l'ordinateur hôte.

Ceci étant, plusieurs cartes peuvent aussi être utilisées pour implanter le banc de test reconfigurable et l'émulateur de sorte que la capacité de ces deux éléments soit augmentée. Il devient alors nécessaire de définir un moyen de communication entre ces deux éléments, permettant dans la mesure du possible de ne pas détériorer les performances globales du système.

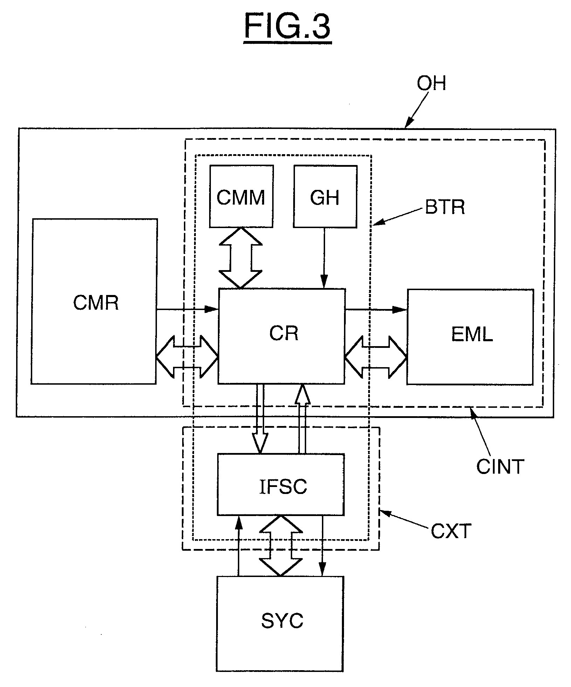

Comme illustré sur la figure 3, le banc de test reconfigurable BTR comporte
une partie centrale CR comportant, comme on le verra plus en détails ci-après, au moins un circuit de contrôle et au moins un circuit reconfigurable,
un générateur d'horloge GH, et
des circuits de mémoire statique et/ou dynamique CMM.

Le générateur d'horloge produit une horloge système de base utile au fonctionnement du banc de test reconfigurable et éventuellement de l'émulateur lorsque les horloges ne proviennent pas du système cible. La source du générateur peut être un quartz ou bien l'horloge provenant de l'interface bus de l'ordinateur hôte.

Les mémoires statiques et/ou dynamiques permettent de stocker certaines informations utiles lors d'une émulation.

Il est également prévu un circuit d'interface externe IFSC, disposé sur une carte externe CXT connectée à la carte interne CINT, ce circuit d'interface réalisant l'interface entre la partie centrale CR du banc de test reconfigurable et le système cible SYC.

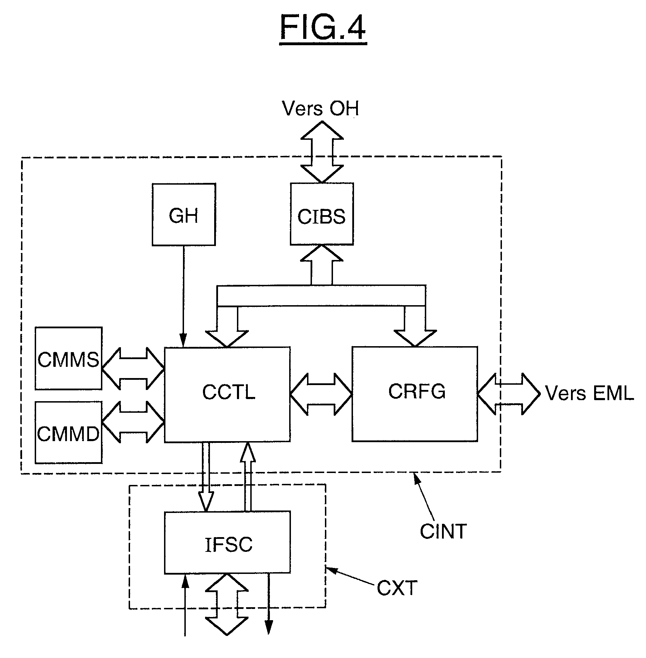

La partie centrale CR du banc de test reconfigurable comporte ici, comme illustré sur la figure 4, un circuit de contrôle CCTL, un circuit reconfigurable d'interface avec l'émulateur CRFG et un circuit interface bus CIBS.

Le circuit d'interface bus CIBS assure la communication de la carte interne CINT avec le bus de l'ordinateur hôte. Cette interface peut être réalisée en utilisant un circuit spécialisé du commerce tels que ceux commercialisés par la société PLX. La connexion du circuit reconfigurable d'interface avec l'émulateur CRFG au circuit d'interface bus CIBS permet d'obtenir une latence minimale dans la communication entre le processeur de l'ordinateur hôte et le circuit sous test. On peut alors utiliser un schéma de connexion avec un bus tri-points (comme indiqué sur la figure 4) ou avec un bus bi-points et un pont entre le circuit reconfigurable d'interface avec l'émulateur CFRG et le circuit de contrôle CCTL. A noter que dans ce dernier cas, il peut être avantageux d'intégrer la fonction d'interface avec le bus de l'ordinateur hôte dans le circuit de contrôle CCTL. Si ce dernier est réalisé par un circuit reconfigurable de type Xilinx, on pourra par exemple utiliser une macro d'interface PCI proposée par ce même fabriquant de circuits reconfigurables.

Le circuit de contrôle réalise les fonctions fixes du banc de test reconfigurable. Son contenu est donc défini indépendamment du circuit sous test et de l'environnement de test utilisé. Il peut comporter néanmoins certaines parties programmables.

Le circuit reconfigurable d'interface avec l'émulateur CRFG sert à réaliser l'interface du banc de test reconfigurable avec l'émulateur du circuit sous test EML. Ce circuit CRFG réalise aussi les parties matérielles de l'environnement de test qui seront définies par l'utilisateur. Le contenu de ce circuit dépend donc de l'environnement de test utilisé et de son interface avec le circuit sous test.

Les circuits de mémoire CMM comportent des circuits de mémoire statique CMMS, par exemple du type SRAM ou SSRAM, ainsi que les circuits de mémoire dynamique, par exemple de type SDRAM. Les mémoires dynamiques peuvent être implantées avec des composants mémoire séparés ou en utilisant des barrettes mémoire. Les composants mémoire présentent l'avantage de faciliter la phase de placement routage sur la carte alors que les barrettes ajoutent plus de souplesse en ce qui concerne l'évolution ultérieure du produit.

L'architecture matérielle du banc de test reconfigurable, tel qu'illustrée sur la figure 4, présente l'avantage de proposer un découplage entre le coeur proprement dit du banc de test reconfigurable réalisant les fonctions critiques au niveau de la vitesse de fonctionnement et son interface avec l'émulateur du circuit sous test nécessitant plus de reconfigurabilité. Ceci donne un meilleur contrôle des parties critiques au niveau vitesse de fonctionnement et permet d'éviter de compiler le circuit de contrôle lorsque l'environnement de test change. La solution qui consisterait à n'utiliser qu'un seul circuit reconfigurable pour réaliser à la fois le circuit de contrôle et l'interface avec l'émulateur du circuit sous test présente cependant les avantages d'une conception simplifiée et d'un coût moindre.

Alors que l'on a représenté ici un seul circuit reconfigurable d'interface CRFG, il serait également possible d'en prévoir plusieurs, par exemple deux, reliés au même circuit de contrôle.

Comme indiqué précédemment, le circuit de contrôle réalise les fonctions de base du banc de test reconfigurable. Ces fonctions sont indépendantes de l'environnement de test du circuit à émuler. Le circuit de contrôle est initialisé au démarrage de la carte et ceci indépendamment des circuits sous test qui seront par la suite émulés.

Le banc de test reconfigurable comprend un bus interne principal appelé bus de communication, se répartissant à la fois sur le circuit de contrôle et le ou les circuits reconfigurables d'interface CRFG. Le bus de communication n'est pas complètement contrôlé par l'ordinateur hôte, même si celui-ci est directement ou indirectement à l'origine de nombreuses transactions. Ainsi, à tout moment, tout bloc matériel connecté au bus peut chercher à communiquer avec un autre bloc sans que l'initiateur de cette transaction soit forcément l'ordinateur hôte.

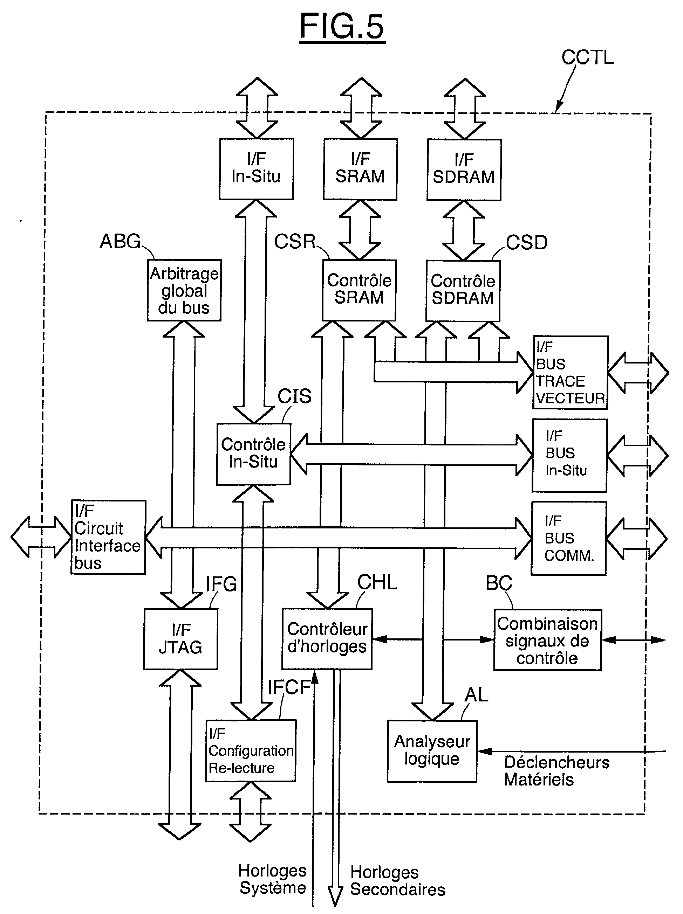

Les accès au bus de communication sont gérés par un bloc d'arbitrage global ABG dans le circuit de contrôle (figure 5) et par un bloc d'arbitrage local dans chaque circuit d'interface de l'émulateur. Un bloc du circuit de contrôle peut donc communiquer avec un bloc du circuit reconfigurable d'interface d'une façon transparente, c'est-à-dire comme si ce dernier faisait partie du circuit de contrôle. Plusieurs mécanismes d'arbitrage peuvent être utilisés pour déterminer quel bloc matériel va prendre la main à un moment donné. A titre d'exemple, un mécanisme d'arbitrage peut consister à faire tourner les priorités à chaque cycle du bus de communication de sorte qu'une requête d'accès au bus finisse toujours par être servie.

Le circuit de contrôle comporte également la partie contrôle d'un analyseur logique matériel AL. Ce bloc est constitué d'un ou de plusieurs automates programmables dont l'état évolue en fonction des déclencheurs prédéfinis ou programmables produits par le circuit reconfigurable d'interface de l'émulateur CRFG, ainsi qu'un ensemble de compteurs et de drapeaux internes. Ce bloc matériel permet de contrôler une séquence de simulation et d'exploiter au mieux les mémoires de trace que l'on réalise en s'appuyant sur les mémoires statiques ou dynamiques connectées au circuit de contrôle. L'analyseur logique ainsi formé reprend les caractéristiques générales d'un analyseur logique classique à ceci près qu'il bénéficie des propriétés des reconfigurations du circuit reconfigurable d'interface pour réaliser un moniteur matériel de trace et les déclencheurs.

Un contrôleur d'horloges CHL est synchronisé par une horloge système de base (ou horloge primaire) qui peut aussi servir avantageusement à cadencer le bus de communication du banc de test reconfigurable. Le contrôleur d'horloges produit des groupes de signaux d'horloges dîtes secondaires, correspondant aux horloges du circuit sous test et aux horloges des différents pilotes/moniteurs et des interfaces de pilotes/moniteurs que l'on retrouve dans le ou les circuits reconfigurable d'interface avec l'émulateur. Le contrôleur d'horloges CHL peut aussi recevoir en entrée des horloges provenant du système cible lorsque le circuit sous test est synchronisé entièrement ou pour partie par des horloges externes.

Le contrôleur d'horloge inclut plusieurs générateurs indépendants fournissant les signaux d'horloges secondaires. Les horloges secondaires produites par un générateur sont liées entre elles selon des rapports de fréquence et de phase déterminés. Chaque générateur peut communiquer avec différents blocs matériels du banc de test reconfigurable pour déterminer l'avancement des horloges secondaires qu'il doit fournir au circuit sous test et aux pilotes/moniteurs. Ainsi un pilote logiciel peut par exemple ralentir une horloge produite par un générateur pour que celle-ci s'adapte à son rythme de stimulation, ou un pilote matériel de trace peut inhiber certaines horloges secondaires provenant de certains générateurs pendant un certain laps de temps pour réaliser un transfert des données de la mémoire de trace vers l'ordinateur hôte. Un bloc BC de combinaison des signaux de contrôle centralise les signaux de contrôle provenant ou allant vers les différents blocs matériels intervenant dans le contrôle des horloges.

Un contrôleur CSD des mémoires dynamiques SDRAM permet de lire ou d'écrire les mémoires dynamiques connectées au circuit de contrôle CCTL à partir de l'ordinateur hôte ou du circuit reconfigurable d'interface CRFG. D'une façon analogue, un contrôleur CSR des mémoires statiques SRAM permet de lire ou d'écrire les mémoires statiques connectées au circuit de contrôle CCTL à partir de l'ordinateur hôte ou du circuit reconfigurable d'interface CRFG. Pendant une simulation, ces mémoires sont utilisées pour échantillonner les données provenant du bus d'interface avec l'émulateur du circuit reconfigurable d'interface CRFG. Ces mémoires peuvent aussi être utilisées pour d'autres usages tels que mémoriser différentes configurations de l'émulateur du circuit sous test, conserver des vecteurs de test ou encore des applications logicielles exécutées par un modèle matériel d'un système complet.

Le circuit de contrôle CCTL comporte également une interface de test IFG, conforme à la norme JTAG, permettant un accès rapide aux ressources de la carte à partir de l'ordinateur hôte et ceci, sans passer par un câble externe. Une telle interface peut être utilisée d'une manière classique pour réaliser des tests de production en vérifiant en particulier la qualité des connexions entre les différents composants de la carte. Cette interface sert aussi, lors du démarrage de la carte, pour identifier les circuits reconfigurables utilisés sur la plate-forme. Le bloc de contrôle CCTL comporte également une interface de configuration et de relecture IFCF, qui permet de configurer ou de relire la configuration des différents circuits reconfigurables du système d'émulation.

Un contrôleur in-situ CIS permet la mise en oeuvre de l'émulation in-circuit en initialisant le circuit d'interface externe IFSC et en contrôlant la communication entre le circuit sous test émulé et le système cible.

Enfin, le circuit de contrôle CCTL comporte des interfaces I/F vers différents composants externes au circuit de contrôle.

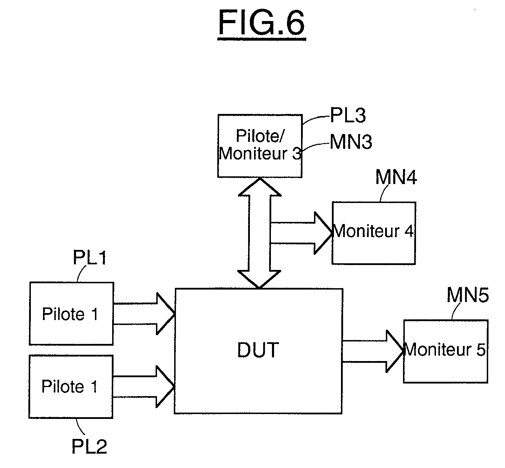

En ce qui concerne l'environnement de test, comme le montre la figure 6, celui-ci est modélisé comme un ensemble de pilotes/moniteurs PLi et MNi interagissant avec le circuit sous test DUT. Les pilotes PLi servent à stimuler le circuit sous test tandis que les moniteurs MNi servent à observer, c'est-à-dire à analyser la réponse du circuit sous test.

Les pilotes/moniteurs sont définis par l'utilisateur à des niveaux d'abstraction différents (description matérielle, programmes,...) et correspondent à des modèles logiciels ou matériels.

Dans le monde de l'émulation, l'objectif est d'accélérer non seulement le circuit sous test mais aussi la plus grande partie de l'environnement de test.

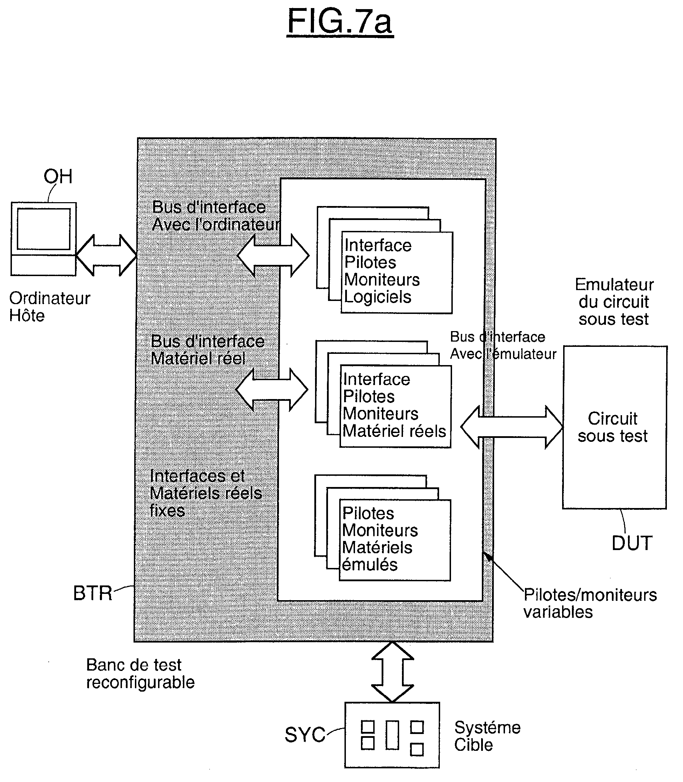

Dans le cas du système d'émulation selon l'invention, on distingue alors les pilotes/moniteurs stimulant le circuit sous test à partir du logiciel, appelés pilotes/moniteurs logiciels, de ceux pouvant être émulés ou réalisés par du matériel réel, appelés pilotes/moniteurs matériel. La figure 7a illustre schématiquement la structure générale du banc de test reconfigurable BTR où l'on a illustré les différents pilotes/moniteurs et interface de pilotes/moniteurs de l'environnement de test.

On rappelle ici que la partie fixe du banc de test reconfigurable réalise les fonctions d'interfaçage avec l'ordinateur hôte et le système cible et qu'elle réalise aussi les.fonctions d'un analyseur logique.

La partie variable, c'est-à-dire reconfigurable, réalise la partie matérielle émulée de l'environnement de test que l'on peut voir comme un ensemble de blocs matériels s'interfaçant avec le circuit sous test pour le stimuler et l'observer. Ces blocs matériels communiquent par ailleurs à travers différents bus avec l'ordinateur hôte OH, le système cible SYC et les ressources matérielles réelles supplémentaires de la partie fixe du banc de test reconfigurable BTR.

Il existe trois types de blocs matériels :
- Interface de pilotes/moniteurs logiciels : il s'agit des interfaces de pilotes/moniteurs de stimulation logicielle établissant une communication avec un processus logiciel exécuté sur l'ordinateur hôte ;
- Pilotes/moniteurs matériels émulés : il s'agit de pilotes/moniteurs de stimulation matérielle qui sont directement émulées dans le banc de test reconfigurable.
- Interfaces de pilotes/moniteurs matériels réels: il s'agit des interfaces de pilotes/moniteurs de stimulation matérielle réelle établissant une communication avec des ressources matérielles du banc de test reconfigurable, ou avec un système externe, tel que le système cible

Dans les deux derniers cas, les blocs matériels associés ne mobilisent que des ressources matérielles émulées ou réelles et ils ne communiquent pas nécessairement avec l'ordinateur hôte quand ils stimulent et observent le circuit sous test.

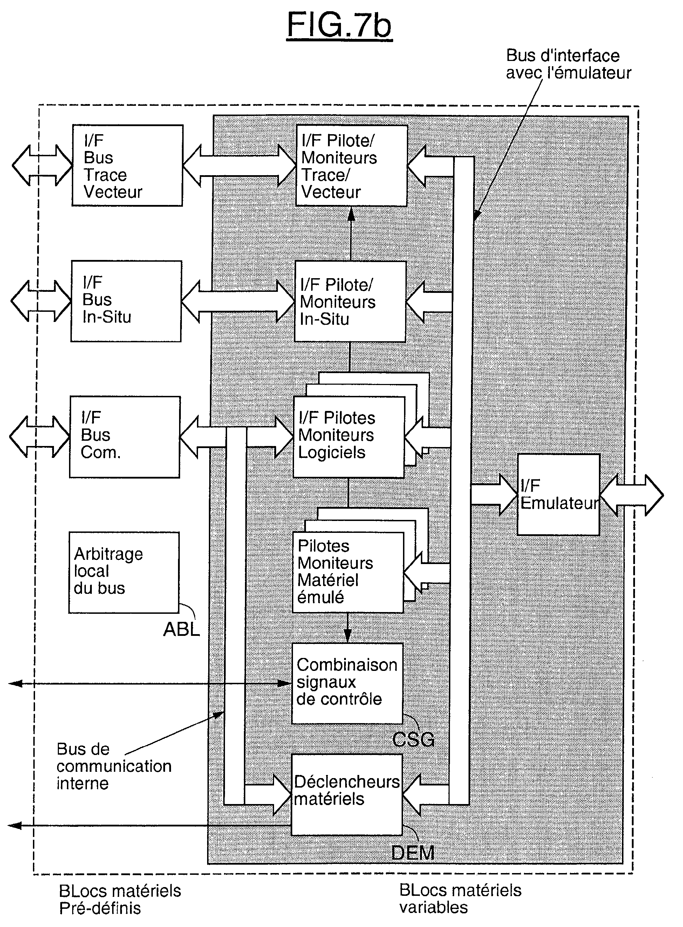

La figure 7b illustre le contenu du circuit reconfigurable d'interface CRFG. Ce circuit reconfigurable d'interface comporte des blocs matériels pré-définis (ou modules système) telles que les interfaces des bus connectés au circuit de contrôle CCTL ou encore le bloc d'arbitrage local ABL et il comporte aussi des blocs matériels variables qui sont générés en fonction des pilotes/moniteurs utilisés dans l'environnement de test.

Le bus de communication interne du banc de test reconfigurable est étendu dans le circuit reconfigurable d'interface CRFG. Certains blocs matériels du circuit reconfigurable d'interface CRFG tels que les interfaces de pilotes/moniteurs logiciels et le bloc de calcul des déclencheurs matériels peuvent ainsi accéder d'une façon transparente au bus de communication interne. Un bloc d'arbitrage local ABL détermine les accès au bus de communication en fonction des requêtes des blocs matériels qui lui sont connectés.

Un bloc de calcul des déclencheurs matériels intègre à la fois des déclencheurs programmables réalisant des comparaisons simples entre un ou plusieurs signaux du bus d'interface avec l'émulateur et un état logique donné, et des déclencheurs générés à la compilation en fonction des besoins en terme d'analyse logique. Il peut s'agir par exemple d'une comparaison entre deux signaux vectorisés du bus d'interface avec l'émulateur. Ce bloc de calcul des déclencheurs matériels peut être considéré comme le bloc matériel d'un moniteur matériel du circuit sous test, même si ce moniteur n'apparaît pas explicitement dans l'environnement de test d'origine.
Un bloc CSC de combinaison des signaux de contrôle centralise les signaux de contrôle provenant ou allant vers les différents blocs matériels intervenant dans le contrôle des horloges et communique avec le bloc BC du circuit de contrôle CCTL.

Le circuit reconfigurable d'interface CRFG comporte ensuite les blocs matériels correspondant aux interfaces de pilotes/moniteurs et les pilotes/moniteurs nécessaires à la stimulation et l'observation du circuit sous test. Comme pour le bloc matériel de calcul des déclencheurs, ces blocs matériels sont connectés entièrement ou pour partie au bus d'interface avec l'émulateur. Le bus d'interface avec l'émulateur peut aussi servir à véhiculer des signaux entre les blocs matériels, ce qui permet ainsi le déboguage des pilotes/moniteurs matériel émulés ou des transacteurs (interfaces de pilotes/moniteurs logiciels de niveau transactionnel) en ré-utilisant les même moyens de déboguage que ceux du circuit sous test.

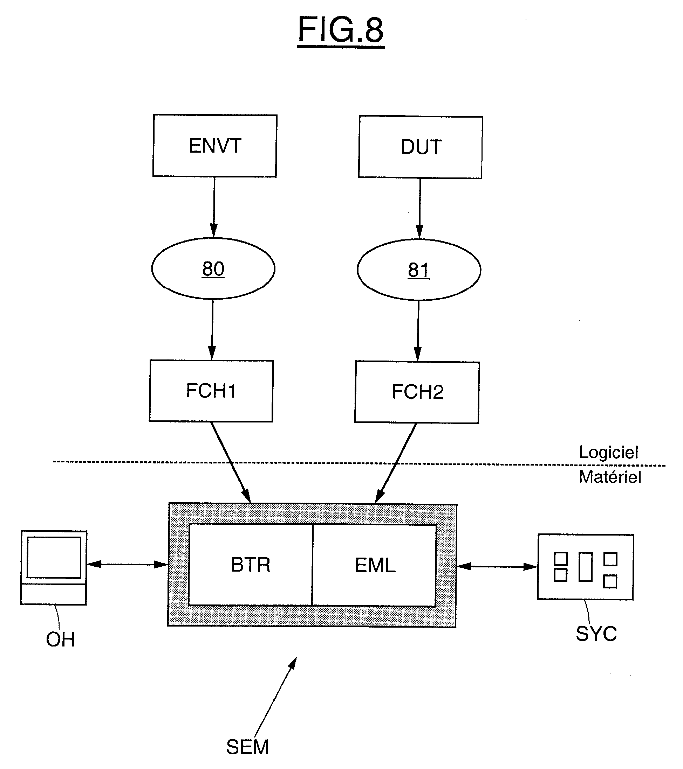

La figure 8 montre un mode général de mise en oeuvre du procédé d'émulation selon l'invention.

A partir d'une description de l'environnement de test ENVT, on génère dans une première phase de génération 80 un premier fichier de configuration FCH1 destiné à configurer le banc de test reconfigurable, et plus précisément le circuit reconfigurable CRFG.

A partir d'une description du circuit sous test DUT, on génère dans une deuxième phase de génération 81, un deuxième fichier de configuration FCH2 destiné à configurer l'émulateur EML du circuit sous test.

Ces deux phases de génération peuvent être effectuées séquentiellement, selon un ordre quelconque, ou bien en parallèle.

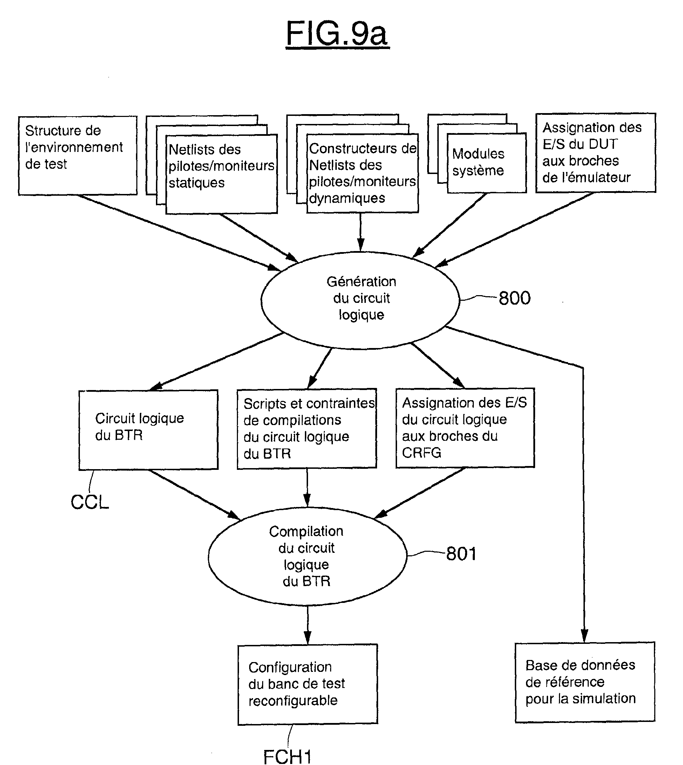

La figure 9a montre le flot général de génération de la configuration du banc de test reconfigurable dans le cas où le circuit sous test a déjà été compilé sur son émulateur. La génération de cette configuration est scindée en deux étapes distinctes :
- la génération 800 d'un circuit logique CCL constitué d'un réseau de portes logiques (ou netlist) représentatives de l'environnement de test, ainsi que des directives de compilation, et
- une compilation 801 de ce circuit logique CCL compte tenu desdites directives, de façon à obtenir le fichier de configuration FCH1 qui va permettre de configurer le banc de test reconfigurable.

L'étape de génération 800 du circuit logique va également fournir une base de données de références pour la simulation, qui va permettre au logiciel de savoir comment initialiser le banc de test reconfigurable et comment communiquer avec le banc de test reconfigurable pour stimuler/observer le circuit sous test et finalement récupérer certains résultats de la simulation.

Le générateur du circuit logique appelé aussi GenFW utilise, lorsque le circuit sous test a déjà été compilé sur son émulateur, les paramètres d'entrée suivants :
- description de l'assignation des entrées/sorties logiques du circuit sous test aux broches de l'émulateur,
- description de la structure de l'environnement de test: il s'agit de la manière dont les pilotes/moniteurs sont connectés au circuit sous test (ceux-ci incluant aussi les horloges), avec d'éventuels paramètres définissant les conditions d'utilisation de ces pilotes/moniteurs, et par ailleurs la définition des déclencheurs pré-définis,
- des netlists de pilotes/moniteurs statiques : il s'agit des pilotes/moniteurs dont le bloc matériel à inclure dans le circuit reconfigurable d'interface CRFG, est fourni directement sous la forme d'un réseau de portes,
- des constructeurs de netlists de pilotes/moniteurs dynamiques : il s'agit des pilotes/moniteurs dont le bloc matériel à inclure dans le circuit reconfigurable d'interface CRFG, est produit sous la forme d'un réseau de portes par un module logiciel appelé dynamiquement par le générateur GenFW
- des modules système : ce sont les blocs matériels pré-définis nécessaires à l'intégration des blocs matériels des pilotes/moniteurs dans le banc de test reconfigurable.

Pour ce qui concerne les blocs matériels relatifs aux pilotes/moniteurs, le générateur GenFW charge donc des netlists fixes correspondant à des pilotes/moniteurs qualifiés de « statiques » ou des netlists générées à la volée (ou dynamiquement) par des modules logiciels et correspondant à des pilotes/moniteurs qualifiés de « dynamiques ».

Les netlists des pilotes/moniteurs statiques et les modules logiciels invoqués par GenFW pour produire les netlists des pilotes/moniteurs dynamiques sont fournis avec GenFW, ou sont développés par l'utilisateur ou par un tiers.

Le générateur GenFW construit aussi le bloc matériel permettant de combiner certains signaux de contrôle et le bloc matériel correspondant aux déclencheurs matériels. Il assemble enfin tous les blocs matériels fournis ou générés pour produire le circuit logique sous la forme d'un réseau de portes qui va servir de base à la reconfiguration du banc de test reconfigurable et plus particulièrement du circuit reconfigurable d'interface CRFG.

Le générateur GenFW fournit toutes les entrées nécessaires au logiciel de compilation du circuit logique pour produire le fichier binaire de configuration FCH1 du circuit reconfigurable CRFG. Les fichiers générés sont les suivants:
- la netlist décrivant le circuit logique,
- des directives de compilation du circuit logique, c'est à dire :
   - des scripts automatisant la compilation du circuit logique et des contraintes temporelles et/ou de placement pour assurer le fonctionnement, du circuit logique à une fréquence élevée
   - une assignation des entrées/sorties du circuit logique aux broches du circuit reconfigurable d'interface CRFG
- une base de donnée de référence nécessaire à la simulation permettant au logiciel de communiquer d'une manière générale avec le banc de test reconfigurable

La base de données de référence pour la simulation contient différents fichiers produits à la fois par les modules logiciels de génération de netlist de pilotes/moniteurs et le générateur GenFW.

Il est également possible de compiler le banc de test reconfigurable avant de compiler le circuit sous test.

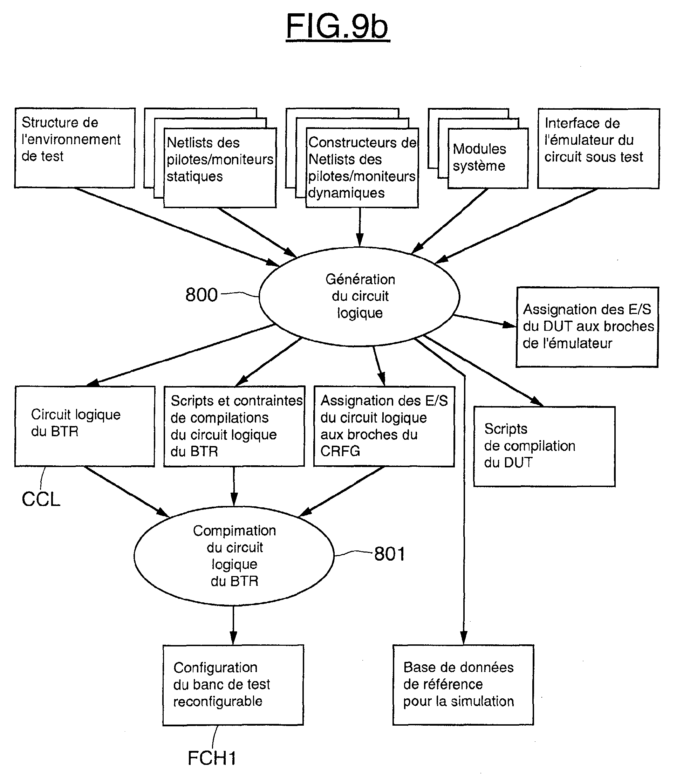

Dans ce cas qui est illustré par la figure 9b, la génération du circuit logique est aussi en charge d'effectuer l'assignation des entrées-sorties du circuit sous test aux broches de l'émulateur du circuit sous test. La génération du circuit logique utilise alors comme paramètre d'entrée une description de l'interface du circuit sous test, qui peut venir par exemple sous la forme d'une netlist représentant la totalité du circuit sous test ou simplement l'interface du modèle de plus haut niveau. L'assignation des entrées-sorties du circuit sous test aux broches de l'émulateurs peut être faite d'une manière aléatoire ou d'une façon plus déterministe en appliquant des heuristiques permettant d'obtenir une assignations plus optimales. De plus, la génération du circuit logique fournit en sortie des directives de compilation pour le circuit sous test à travers des scripts de compilation et une description de l'assignation des entrées/sorties logiques du circuit sous test aux broches de l'émulateur, cette description de sortie étant par ailleurs un paramètre de contrainte pour la compilation du circuit sous test sur l'émulateur.

On va maintenant décrire plus en détails la fonctionnalité des moyens de génération genFW du circuit logique dans le cas où le circuit reconfigurable d'interface CRFG et l'émulateur du circuit sous test sont basés sur un circuit reconfigurable du type FPGA de la société XILINX. Dans ce cas, l'étape de compilation s'effectue à l'aide d'un logiciel de compilation, appelé aussi outil de placement & routage, tel que le logiciel ISE 4.2 commercialisé par la société XILINX. Dans la suite du texte et à des fins de simplification, les moyens de génération GenFW seront désignés par leur référence GenFW, et le circuit sous test sera désigné par sa référence DUT.

En se referant à nouveau à la figure 9a, la compilation du DUT par le logiciel de compilation XILINX fournit un fichier d'extension « .pad », d'assignation des entrées-sorties du DUT aux broches du circuit reconfigurable d'émulation. Ce fichier contient la liste de ses entrées-sorties, avec leur direction et la broche physique du circuit reconfigurable (FPGA) sur laquelle elles sont assignées. La prise en compte de ces informations permet à GenFW de placer correctement les entrées-sorties du banc de test reconfigurable en générant une assignation des entrées-sorties du circuit logique pour le circuit reconfigurable d'interface CRFG. Cette assignation est produite sous la forme d'un fichier d'extension « .ucf », décrivant les contraintes pour le logiciel de compilation Xilinx.

La structure de l'environnement de test est décrite par un fichier d'extension « .dve », donnant la liste des pilotes/moniteurs instanciés dans l'environnement de test et la définition des déclencheurs matériels. Pour chaque pilote/moniteur, ce fichier décrit la connexion au DUT et éventuellement à d'autres pilotes/moniteurs (ceci incluant aussi le bloc de calcul des déclencheurs matériels) selon une syntaxe proche du langage Verilog. Il contient aussi les différents paramètres (directives 'defparam') qui permettent de configurer chaque pilote/moniteur et de définir sur quelles horloges un pilote/moniteur se synchronise. Un exemple est donné ci-dessous :

```
  // Instanciation d'un pilote matériel émulé générant
  // des nombres aléatoires
  randomModel randgen (
     .clk(clk0),
     .val(din[15:0])) ;
  zceiClockPort dut_clock0 (.cclock(clk0));
  assign trigger0= din[0] || din[1];
```

Un circuit est stimulé par un pilote matériel émulé dont le nom de modèle est 'randomModel'. Le fichier « .dve » indique sous quel nom le modèle du pilote doit être instancié dans le circuit logique ('randgen') et comment le pilote est connecté au circuit sous test. Ainsi le connecteur 'clk' du pilote est connecté à l'horloge 'clk0' du circuit sous test, et le connecteur 'val' est connecté à l'entrée vectorisé 'din' de ce même circuit sous test. Le déclencheur 'trigger0' est défini comme étant une fonction OU sur les signaux 'din[0]' et 'din[1]', de sorte que 'trigger0' est actif lorsque l'un des deux signaux 'din[0]' ou 'din[1]' est actif.

Il est à noter que la structure de l'environnement de test pourrait tout aussi bien être décrite par une description matérielle dans un langage tel que VHDL ou Verilog. De plus dans certains cas (environnement de test monolithique, c'est à dire constitué d'un seul pilote/moniteur stimulant/observant toutes les entrées/sorties du circuit sous test), le fichier « .dve » peut être lui-même généré automatiquement par le programme GenFW en s'appuyant sur la description de l'interface du circuit sous test.

GenFW supporte l'instanciation de pilotes/moniteurs matériels ou logiciels directement fournis avec le système d'émulation selon l'invention, mais aussi de pilotes/moniteurs développés par l'utilisateur ou par des tiers. Un cas typique de pilote/moniteur développé par l'utilisateur correspond au pilote/moniteur matériel émulé. L'utilisateur fournit simplement une netlist EDIF de son pilote/moniteur, qui sera instancié par GenFW dans le circuit reconfigurable d'interface CRFG. Un cas typique de pilote/moniteur développé par des tiers concerne les transacteurs. Dans ce cas, l'interface de pilote/moniteur logiciel transactionnel peut venir soit directement sous la forme d'une netlist EDIF, soit peut être générée par un module logiciel selon certains paramètres définis dans le fichier « .dve ». GenFW doit donc pouvoir invoquer un tel module logiciel avec ses bons paramètres et pouvoir récupérer la netlist EDIF résultante pour l'insérer dans le circuit reconfigurable d'interface CRFG.

GenFW permet de mettre en oeuvre une approche générique où chaque bloc matériel de pilote/moniteur est traité d'une façon indifférente, indépendamment de ses caractéristiques, de qui le conçoit et de la façon dont il est produit. Certains pilotes/moniteurs sont fournis avec le système d'émulation selon l'invention, mais d'autres peuvent être développés par l'utilisateur ou un tiers.

Chaque pilote/moniteur est lié à un répertoire qui contient les informations nécessaires à la génération éventuelle et à l'utilisation du bloc matériel à insérer dans le circuit reconfigurable d'interface CRFG. Ce répertoire contient en particulier un fichier d'extension « .install » qui indique le type du pilote/moniteur (statique/dynamique) et la méthode de production de la netlist dans le cas d'un pilote/moniteur dynamique.

Dans le cas d'un pilote/moniteur statique, le fichier d'extension « .install » spécifie simplement le nom de la netlist EDIF à charger par GenFW.

Un exemple de fichier « .install » est donné ci-dessous pour un pilote/moniteur statique de nom DLX_ROM :

```
 // Définition d'une interface de pilote/moniteur simulant la ROM-
 programme du processeur DLX
 // fichier : DLX_ROM.install
 DLX_ROM {
        NETLIST = "dlx_rom.edif" ;
        }
```

Dans cet exemple, le fichier « .install » indique le nom du fichier de netlist EDIF à charger dans genFW, en l'occurrence 'dlx_rom.edif'.

Un pilote/moniteur dynamique est construit par un module logiciel capable de générer la netlist EDIF à insérer dans le circuit reconfigurable d'interface CRFG. Le module logiciel correspond à un fichier script, un programme exécutable, un ou plusieurs fichiers décrivant un modèle matériel à synthétiser, ou enfin une bibliothèque chargeable dynamiquement dans GenFW. Le module logiciel doit comporter un point d'entrée de sorte que GenFW puisse invoquer la génération de la netlist du bloc matériel du pilote/moniteur avec certains paramètres de génération. Dans le cas d'une bibliothèque dynamique, cette fonction de génération est appelée par GenFW en lui fournissant en paramètres toutes les informations relatives à une instanciation du pilote/moniteur telles que décrites dans le fichier ".dve". Un exemple de fichier « .install » pour un pilote/moniteur dynamique, est donné ci-dessous :

```
 // Définition du pilote de cosimulation C
 // fichier : C_COSIM.install
 C_COSIM {
       LIB_NAME = "genCCosim.so" ; // bibliothèque dynamique
       FCT_NAME = "genCCosimNetlist" ; // fonction principale
       }
```

Le module logiciel est décrit comme étant une bibliothèque dynamique ('genCCosim.so') à laquelle GenFW va se lier dynamiquement. Le point d'entrée du module logiciel est la fonction 'genCCosimNetlist' qui est appelée par GenFW avec un prototype particulier.

Ce prototype comporte comme paramètre la structure de données représentant l'instanciation du pilote/moniteur dans le ".dve" (nom d'instance, connexions au DUT, directives 'defparam'...).

La fonction fournit une netlist à GenFW qui se charge de l'instancier dans la netlist du circuit reconfigurable d'interface CRFG.

A noter que le module logiciel (à travers la fonction 'genCCosimNetlist') peut aussi fournir des informations venant compléter la base de données de références pour la simulation.

Ainsi, le générateur de pilote/moniteur de cosimulation C (genCCosim.so) produit un fichier C (ou C++) qui contient les structures de données et les fonctions nécessaires à l'utilisateur pour stimuler, à partir d'une application C (ou C++), les signaux du DUT qu'il a relié au pilote/moniteur de cosimulation (connexions explicitées dans le fichier d'extension ".dve").

GenFW produit finalement une netlist au format EDIF pour le circuit logique, qui sert de base pour la configuration du circuit reconfigurable d'interface CRFG.

Cette netlist inclut la description et réalise l'interconnexion des différents blocs matériels des pilotes/moniteurs et des modules systèmes.

GenFW produit également un fichier d'extension « .ucf » pour exprimer les contraintes de placement des entrées-sorties du circuit logique sur le circuit reconfigurable d'interface CRFG. Ce fichier, destiné au logiciel de compilation Xilinx, contient aussi des contraintes temporelles (notamment pour les blocs d'interface du circuit reconfigurable CRFG avec le circuit de contrôle CCTL).

Au niveau de la base de données de références pour la simulation, GenFW génère également le fichier contenant la liste des blocs matériels introduits dans la netlist du circuit logique réalisé par le circuit reconfigurable d'interface CRFG et nécessitant une interaction (initialisation ou communication) avec le logiciel.

Ce fichier contient notamment :
- la liste des horloges utilisées par le circuit sous test et les pilotes/moniteurs de l'environnement de test
- la liste des pilotes/moniteurs ayant un accès au bus de communication du banc de test reconfigurable. L'accès au bus est mis en oeuvre par un ou plusieurs ports de communication (en émission et réception) présents dans la netlist du bloc matériel de chaque pilote/moniteur.

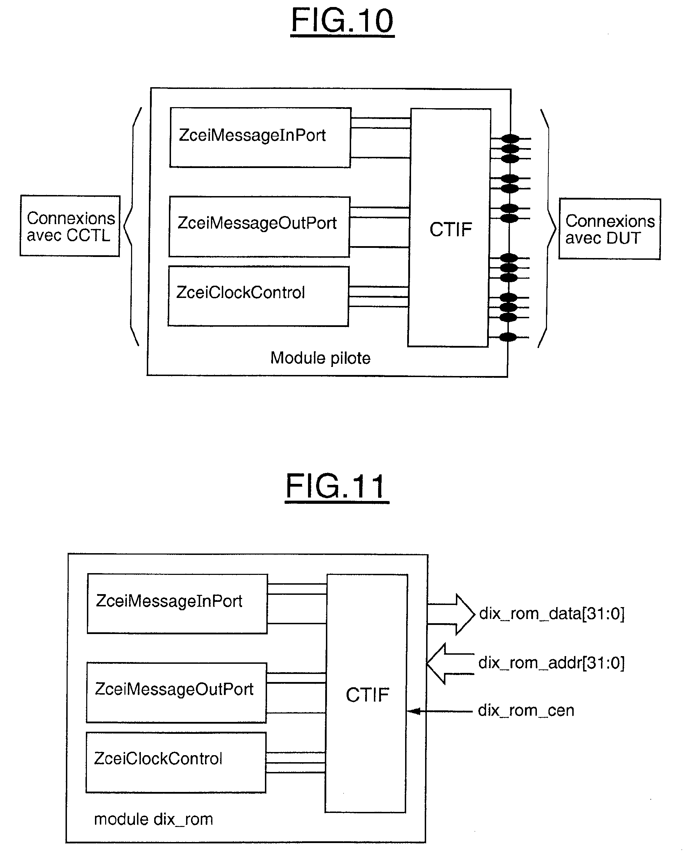

La figure 10 illustre schématiquement l'architecture d'un bloc matériel correspondant à une interface de pilote/moniteur logiciel.

L'architecture des interfaces de pilotes/moniteurs logiciels et la sémantique de connexion reprennent certains principes de la norme SCE-MI, mais celle-ci a été adaptée pour pouvoir aussi établir une communication avec le logiciel au niveau bit/signal.

Le bloc matériel d'une interface de pilote/moniteur logiciel contient un module CTIF qui communique d'un coté avec le DUT (selon les connexions qui ont été décrites explicitement dans le fichier « .dve ») et de l'autre coté avec le bus de communication du banc de test reconfigurable à travers des cellules particulières appelées « ports » de communication.

Ces ports de communication qui sont instanciés dans la netlist du bloc matériel de l'interface du pilote/moniteur logiciel, peuvent être de trois types différents :
- ZceiMessageInPort : permet l'envoi de messages depuis le logiciel vers le module CTIF
- ZceiMessageOutPort : permet l'envoi de messages depuis le module CTIF vers le logiciel,
- ZceiClockControl : permet de contrôler l'avancement de l'horloge appliquée au DUT (appelé aussi mécanisme de « rétro-contrôle ») et qui est aussi associée au pilote/moniteur.

Le rôle de GenFW est donc, une fois lue ou construite la netlist du bloc matériel de l'interface du pilote/moniteur logiciel:
- de relier les connecteurs de la netlist aux signaux internes du circuit logique, et en particulier au bus de d'interface avec l'émulateur de sorte que la netlist soit finalement relié aux connecteurs du circuit sous test conformément aux indications du fichier d'extension ".dve"
- de remplacer les boites noires ZceiMessageInPort et ZceiMessageOutPort par des modules connectés au bus de communication du circuit reconfigurable CRFG, lui même étant une extension locale du bus de communication du circuit de contrôle CCTL, et donc permettant l'échange de données avec le logiciel
- de remplacer les boites noires ZceiClockControl par de la logique connectée à des ports externes du circuit reconfigurable CRFG;

La figure 11 illustre un exemple de bloc matériel pour une interface de pilote/moniteur logiciel statique 'dlx_rom'.

Le pilote/moniteur logiciel 'dlx_rom' sert à stimuler le DUT (en l'occurrence un processeur DLX) en simulant par logiciel le fonctionnement d'une mémoire morte (ROM) contenant le programme du DLX.

Les connecteurs du bloc matériel 'dlx_rom' sont :
- dlx_rom_data : vecteur de 32 sorties qui fournit au DLX les données lues dans la mémoire.
- dlx_rom_addr : vecteur de 32 entrées qui génère l'adresse mémoire que veut lire le DLX.
- dlx_rom_cen : une entrée dont la fonction est la sélection de la mémoire par le DLX.

La mise en oeuvre du pilote/moniteur dlx_rom demande son instanciation dans le fichier ".dve", selon la forme suivante :

```
 // instance 'rom_program' d'un pilote/moniteur 'dlx_rom'
 dlx_rom rom_program (
        .dlx_rom_data(rom_data[31:0]),
        .dlx_rom_addr(rom_addr [31:0] ),
        .dlx_rom_cen (rom_cen)
        ) ;
 // L'horloge du DUT CLK est produite par le générateur 'clkprt'
 zceiClockPort clkprt (.cclock(clk));
 // 'DLX_CLK' est un alias de l'horloge du DUT (produite par le
 // générateur 'clkprt')
 defparam clkprt.cclock = DLX_CLK
 // l'instance 'rom_program' du pilote/moniteur retro-contrôle
 l'horloge
 // DLX_CLK, et donc l'horloge du DUT
 defparam rom_program.cclock = DLX_CLK;
```

Ces lignes du fichier ".dve" signifient (pour GenFW) :
- qu'il faut créer une instance nommée 'rom_program' du modèle 'dlx_rom' dans le circuit logique
- que le vecteur de connecteurs 'dlx_rom_data' de l'instance 'rom_program' doit être connecté aux signaux d'entrées 'rom_data[31]' à 'rom_data[0]' du DUT, qui sont accessibles par le bus d'interface avec l'émulateur.
- que le vecteur de connecteurs 'dlx_rom_addr' de l'instance 'rom_program' doit être connecté aux signaux de sortie 'rom_addr[31]' à 'rom_addr[0]' du DUT qui sont accessibles par le bus d'interface avec l'émulateur.
- que le connecteur 'dlx_rom_cen' de l'instance 'rom_program' doit être connecté au signal de sortie 'rom_cen' du DUT qui est accessible par le bus d'interface avec l'émulateur.

La première ligne 'defparam' du fichier ".dve" signifie que l'horloge générée par le générateur 'ZceiClockPort' s'appelle aussi 'DLX_CLK'. La deuxième ligne 'defparam' signifie que cette horloge 'DLX_CLK' est retro-contrôlée par le pilote/moniteur logiciel 'dlx_rom' ce qui indique que le circuit sous test va fonctionner à une fréquence déterminée selon la vitesse de stimulation du pilote/moniteur.

L'exemple suivant illustre le cas d'un pilote/moniteur logiciel dynamique dont les ports sont d'une taille variable.

```
 // instance 'ccode' d'un pilote/moniteur logiciel C_COSIM
 C_COSIM ccode (
        .input_bin({ data[63:0], ack, ctrl[3:0] }),
        .output_bin(({ addr[31:0], wen })
        ) ;
 defparam ccode.cclock = CLK;
 // L'horloge du DUT CLK est produite par le générateur 'clkprt'
 zceiClockPort clkprt (.cclock(clk));
 // CLK est le nom de l'horloge générée pour le DUT
 defparam clkprt.cclock = CLK
  // le pilote/moniteur 'ccode' retro-contrôle l'horloge 'CLK'
 defparam ccode.cclock = CLK;
```

Dans ce fichier d'extension « .dve », les connecteurs 'input_bin' et 'output_bin' du pilote/moniteur C_COSIM n'ont pas de dimension prédéfinie. genFW adapte leur taille en fonction du nombre de signaux qu'il doit connecter.

On va maintenant décrire un autre exemple d'utilisation de GenFW.

Dans cet exemple le circuit DUT à émuler avec le système d'émulation selon l'invention est un compteur 4 bits décrit en langage verilog.

```
  // description du compteur 4bits en langage VERILOG
 module counter_4bits (rst, clk, data);
    input rst, clk;
   output [3:0] data;
   reg [3:0] data;
   always @(posedge clk or posedge rst) begin
     if (rst) data <= 0; // remise a zero du compteur
     else data <= data + 1; // avancement sur front d'horloge 'clk'
   end
  enmodule
```

L'utilisateur doit alors mettre en oeuvre un outil de synthèse logique (par exemple celui connu sous la dénomination leonardo de la société MENTOR GRAPHICS) pour transformer la description VERILOG du compteur en une netlist EDIF. La netlist EDIF obtenue s'appellera 'counter_4bits.edf' dans la suite de l'exemple.

La netlist EDIF 'counter_4bits.edf' sert de point d'entrée décrivant le DUT à la chaîne de compilation XILINX.

Dans cet exemple, l'environnement de test ne comporte qu'un pilote/moniteur logiciel correspondant à un programme en C/C++ fait par l'utilisateur.

```
// instance d'un pilote C_COSIM
  C_COSIM stimul (
       .input_bin (rst),
       .output_bin(data[3:0])
       );
 defparam stimul.cclock = CLK_ID;
 zceiClockPort clock (.cclock(clk)); // clk est une horloge du DUT
 defparam clock.cclock = CLK_ID;
```

Ce fichier, nommé par exemple 'counter_4bits.dve', signifie que l'utilisateur du système d'émulation selon l'invention veut contrôler la valeur de signal 'rst' de remise à zéro du DUT, ainsi que l'avancement de l'horloge 'clk' dans son programme C/C++.

Il veut également lire la valeur du signal 'data[3:0]' produite par le DUT dans son programme.

Dans la suite on présente l'utilisation de GenFW sans compilation préalable du DUT avec le logiciel de compilation XILINX.

L'utilisateur peut appeler GenFW avec la commande :
genFW -edf counter_4bits.edf -dve counter_4bits.dve

Les fichiers d'entrée de genFW sont :
- 'counter_4bits.edf' : la netlist EDIF du DUT,
- 'counter_4bits.dve' : la structure de l'environnement de test.

Les fichiers de sortie sont :
- 'fp_firmware.edf' : la netlist du circuit logique CCL (contenu du circuit reconfigurable CRFG),
- 'fp _firmware.ucf': les contraintes de placement des entrées-sorties du circuit reconfigurable CRFG,
- 'fp _firmware.xref': données pour le logiciel de simulation,
- 'counter_4bits.ucf' : les contraintes de placement des entrées-sorties du circuit reconfigurable formant l'émulateur EML,
- 'stimul.c' : fichier C pour la mise en oeuvre du pilote/moniteur de cosimulation dans le programme C/C++ de l'utilisateur.

Le fichier 'counter_4bits.ucf produit par GenFW contient les contraintes de placement des entrées/sorties du DUT sur les broches du circuit reconfigurable formant l'émulateur EML, qui est par exemple un circuit FPGA désigné dans la suite sous le vocable FPGA DUT.

De même dans la suite le circuit reconfigurable CRFG est désigné sous le vocable FPGA FP.

Le format UCF utilisé est un format propriétaire de XILINX.

```
# contraintes XILINX au format UCF pour counter_4bits
 # le FPGA-DUT est un circuit XCVE1600 FG1156
 NET "data(3)" LOC = "AP15";
 NET "data(2)" LOC = "AL16";
 NET "data(1)" LOC = "AE14";
 NET "data(0)" LOC = "AN16";
 NET "rst" LOC = "AF16";
 NET "clk" LOC = "AH18";
```

Dans ce fichier, AP15, AL16, ..., AH18 sont des noms de broches du FPGA DUT, conformes à la nomenclature de XILINX.

GenFW choisi des broches du FPGA DUT qui sont connectées aux banc de test reconfigurable BTR (afin que le banc de test BTR puisse contrôler les entrées/sorties du DUT). De plus, la broche AH18 utilisée pour l'entrée 'clk' est une broche d'horloge du FPGA DUT : GenFW a décidé de placer 'clk' sur l'un des réseaux d'horloges du FPGA DUT à partir de l'instanciation du 'zceiClockPort' dans le fichier 'counter_4bits. dve'.

Dans cet exemple, le FPGA DUT est un circuit VIRTEX-E 1600 à boîtier 1156 broches ; les noms des broches choisies par GenFW sont compatibles avec ce type de FPGA. L'utilisation d'un autre modèle de FPGA aurait vraisemblablement abouti à un choix différent des broches.

Le fichier 'fp_firmware.edf' est la netlist EDIF du FPGA FP du banc de test reconfigurable. Elle contient l'instance 'stimul' du pilote/moniteur de cosimulation C 'C_COSIM' conformément à ce qui a été décrit précédemment.

Le fichier 'fp_firmware.ucf' contient les contraintes de compilation de la netlist du circuit reconfigurable CRFG par le logiciel de compilation XILINX. Comme l'indique l'extrait ci-dessous, les contraintes décrivent le placement des signaux d'entrées-sorties du circuit logique CCL sur les broches du FPGA FP, mais aussi des contraintes temporelles telles que la fréquence minimale requise pour l'horloge système du banc de test reconfigurable.

```
 # contraintes XILINX au format UCF pour FP
 # le FPGA-FP est du model XCVE1600 FG900
 NET "data(3)" LOC = "F1";
 NET "data(2)" LOC = "G3";
 NET "data(1)" LOC = "L10";
 NET "data(0)" LOC = "E4";
 NET "rst" LOC = "H7";
...
 # autres contraintes non présentées dans cet extrait
...
 # contrainte de fréquence: horloge systeme a 50 Mhz
 TIMESPEC "TS_clk" = PERIOD "sys_clk" 20 ns HIGH 50%
...
```

Dans l'extrait présenté ci-dessus, GenFW a choisi les broches F1, G3, L10, E4 et H7 pour le placement des signaux d'entrées-sorties 'data(3)' ... 'rst' qui doivent être reliés aux signaux de même nom du DUT parce que :
- la broche 'F1' du FPGA FP et reliée à la broche 'AP15' du FPGA DUT
- la broche 'G3' du FPGA FP et reliée à la broche 'AL16' du FPGA DUT
- la broche 'L10' du FPGA FP et reliée à la broche 'AE14' du FPGA DUT
- la broche 'E4' du FPGA FP et reliée à la broche 'AN16' du FPGA DUT
- la broche 'H7' du FPGA FP et reliée à la broche 'AF16' du FPGA DUT.

Dans cet exemple, le FPGA FP est un circuit VIRTEX-E 1600 à boîtier 900 broches ; les noms des broches choisies par GenFW sont compatibles avec ce type de FPGA. L'utilisation d'un autre modèle de FPGA aurait vraisemblablement aboutit à un choix différent des broches.

Le fichier 'fp_firmware.xref' est destiné à l'interface avec le logiciel. Il indique les ressources insérées dans le banc de test reconfigurable permettant le contrôle du système d'émulation par le programme exécuté sur l'ordinateur hôte.

```
 $NbPorts = 2 ;
 $PortSpec_1 = « stimul txp 1 » ;
 $PortSpec_0 = « stimul rxp 0 » ;
 $Clock_0 = "CLK_ID" ;
```

Ce fichier indique que le banc de test reconfigurable généré par genFW contient 2 ports de communication reliant l'interface du pilote/moniteur logiciel 'stimul' au bus de communication du banc de test reconfigurable .
- port 0 (déclaration $PortSpec_0) : port 'rxp' du pilote/moniteur 'stimul' instancié dans le fichier ".dve"
- port 1 (déclaration $PortSpec_1) : port 'txp' du pilote/moniteur 'stimul' instancié dans le fichier ".dve"

Il indique également que le générateur d'horloge numéro 0 est utilisé pour produire l'horloge du DUT référencée sous le nom 'CLK_ID'.

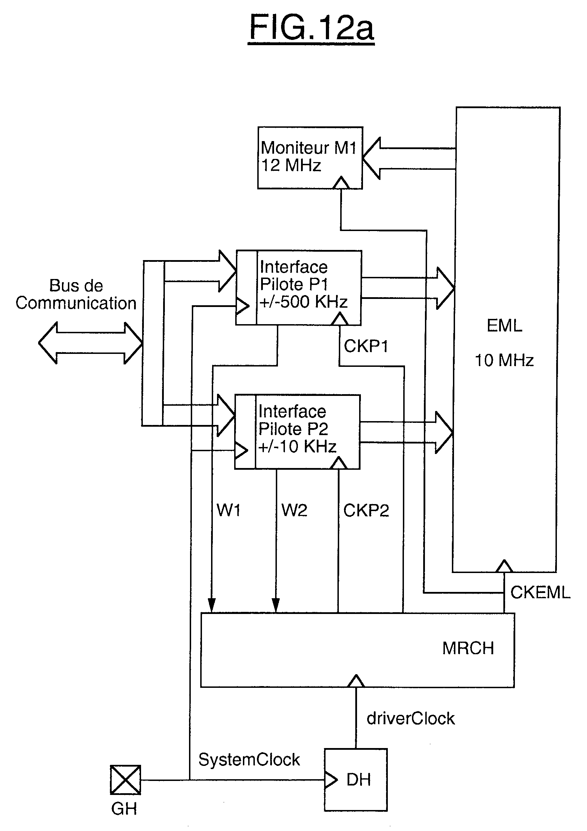

On se réfère maintenant à la figure 12a pour décrire un moyen de rétrocontrôle d'horloge MRCH. En effet alors que le circuit sous test et certains pilotes/moniteurs (généralement de type matériel) peuvent fonctionner à des fréquences élevées (10MHz par exemple), d'autres pilotes/moniteurs (généralement de type logiciel) ne peuvent non seulement pas fonctionner à de telles fréquences en mode continu, mais de plus ne peuvent pas stimuler/observer le circuit sous test à une fréquence constante et pré-déterminée. Sur la figure 12a, deux interfaces de pilotes logiciels P1 et P2 fonctionnant en moyenne respectivement à 10kHz et à 500kHz ont été représentées, de même qu'un moniteur matériel émulé M1 pouvant atteindre une fréquence maximale de fonctionnement de 12 MHz.

Il convient donc de prévoir une horloge à « fréquence variable »,c'est à dire qui puisse s'adapter au mieux aux possibilités des pilotes/moniteurs impliqués dans l'environnement de test.

Dans l'exemple de la figure 12a, on s'intéresse aux moyens de retro-contrôles mis en oeuvre pour produire les horloges secondaires synchronisant l'émulateur du circuit sous test et certains pilotes/moniteurs de l'environnement de test.. Dans le cadre du banc de test reconfigurable, ces moyens de retro-contrôle sont mis en oeuvre par un des générateurs du contrôleur d'horloge CHL du circuit de contrôle CCTL.

Plus précisément, les moyens MRCH, composés de portes logiques reçoivent le signal d'horloge driverClock délivré par le diviseur d'horloge DH cadencé par le signal d'horloge de base systemClock. Le facteur de division est déterminé de façon à ce que la fréquence de l'horloge driverClock ne puisse pas dépasser la fréquence maximale de fonctionnement du circuit sous test émulé et des pilotes/moniteurs matériels.

Les moyens MRCH reçoivent également deux signaux d'attente w1 et w2 émis par les deux pilotes P1 et P2, et délivrent aux deux pilotes logiciels leurs signaux d'horloge respectifs ckp1, ckp2, et au moniteur matériel M1 et à l'émulateur du circuit sous test EML le signal d'horloge ckEML.

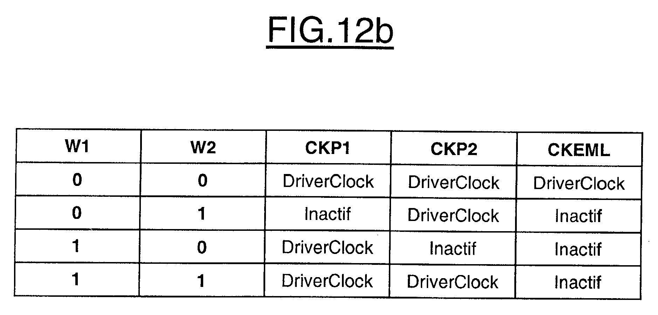

La figure 12b montre une table décrivant le comportement des sorties du bloc MRCH en fonction de ses entrées.

Quand le signal d'attente w1 est à 1 (actif), les signaux ckp2 et ckEML sont arrêtés, mais l'horloge ckp1 reste encore active (il peut s'agir de l'horloge driverClock directe ou divisée).

Quand le signal d'attente w2 est à 1 (actif), les signaux ckp1 et ckEML sont arrêtés, mais l'horloge ckp2 reste encore active (il peut s'agir de l'horloge driverClock directe ou divisée).

Lorsque les deux signaux w1 et w2 sont simultanément à 0 (inactifs), toutes les horloges sont actives.

Lorsque les deux signaux w1 et w2 sont simultanément à 1 (actifs), seule l'horloge ckEML est arrêtée.

Il est à noter que l'on peut diminuer le nombre de signaux d'horloges utilisées dans l'environnement de test en utilisant des signaux d'activation sur l'horloge driverClock, étant donné que lorsque les horloges secondaires sont actives, elles dérivent toutes de l'horloge driverClock.

Ainsi plus généralement le générateur de signaux d'horloges MRCH, synchronisé par l'horloge système de base divisée, délivre différents signaux d'horloge secondaires synchronisant l'émulateur du circuit sous test et certains au moins des moyens matériels du banc de test. Les moyens de rétrocontrôle d'horloge sont alors capables en réponse à au moins un signal d'attente émis par l'un des moyens matériels du banc de test cadencé par un premier signal d'horloge secondaire, d'inhiber temporairement certains des autres signaux d'horloge secondaires de fréquences différentes de celle du premier signal d'horloge secondaire.

## Revendications

1. Procédé d'émulation d'un circuit sous test associé à un environnement de test, comportant deux phases distinctes de génération comportant une première phase de génération (80) d'un premier fichier (FCH1) de configuration de l'environnement de test, et une deuxième phase de génération (81) d'un deuxième fichier (FCH2) de configuration d'au moins une partie du circuit sous test, la délivrance du premier fichier de configuration à une première partie matérielle reconfigurable (BTR) formant un banc de test reconfigurable de façon à configurer le banc de test, et la délivrance du deuxième fichier de configuration à une deuxième partie matérielle reconfigurable (EML) de façon à configurer un émulateur du circuit sous test, les deux parties matérielles étant distinctes et mutuellement connectées, le banc de test reconfigurable comportant un générateur de signaux d'horloges, synchronisé par une horloge système de base et délivrant différents signaux d'horloge secondaires synchronisant l'émulateur du circuit sous test et certains au moins des moyens matériels du banc de test, ainsi que des moyens de rétrocontrôle d'horloge capable en réponse à au moins un signal d'attente émis par l'un des moyens matériels du banc de test cadencé par un premier signal d'horloge secondaire, d'inhiber temporairement certains des autres signaux d'horloge secondaires de fréquences différentes de celle du premier signal d'horloge secondaire.

2. Procédé selon la revendication 1, **caractérisé par le fait que** la première phase de génération (80) comporte la production (800) d'un circuit logique (CRL) constitué d'un réseau de portes logiques et représentatif de l'environnement de test ainsi que des directives de compilation, et une compilation (801) de ce circuit logique compte tenu desdites directives, de façon à obtenir ledit premier fichier de configuration (FCH1).

3. Procédé selon la revendication 2, **caractérisé par le fait que** l'environnement de test comporte un ensemble de pilotes (PLi) et de moniteurs (MNi), et **par le fait que** la production dudit circuit logique comporte la formation de blocs matériels sous la forme de réseaux de portes logiques, ces blocs matériels représentant des interfaces de pilotes/moniteurs de stimulation logicielle, des interfaces de pilotes/moniteurs de stimulation matérielle réelle, et des pilotes/moniteurs de stimulation matérielle émulée, des blocs de calculs de déclencheurs matériels, ainsi qu'un bloc d'interface avec l'émulateur du circuit sous test.

4. Procédé selon la revendication 3, **caractérisé par le fait que** la phase de formation des blocs matériels se fait à partir de réseaux de portes définis statiquement ou de réseaux de portes générés dynamiquement par un module logiciel.

5. Procédé selon l'une des revendications précédentes, **caractérisé par le fait que** la première phase de génération (80) et la deuxième phase de génération (81) sont effectuées en parallèle.

6. Procédé selon l'une des revendications 1 à 4, **caractérisé par le fait que** la première phase de génération (80) et la deuxième phase de génération (81) sont effectuées séquentiellement.

7. Procédé selon la revendication 6, **caractérisé par le fait qu'**on effectue la première phase de génération (80) avant ou après la deuxième phase de génération (81).

8. Procédé selon les revendications 3 et 7, **caractérisé par le fait que** lorsque la première phase de génération est effectuée après la deuxième phase de génération, la production du circuit logique (CRL) utilise comme paramètres d'entrée une description de l'assignation des entrées/sorties logiques du circuit sous test aux broches de l'émulateur, et **par le fait que** lorsque la deuxième phase de génération est effectuée après la première phase de génération, la production du circuit logique utilise comme paramètres d'entrée une description de l'interface du circuit sous test et fournit en sortie une description de l'assignation des entrées/sorties logiques du circuit sous test aux broches de l'émulateur, cette description de sortie étant alors un paramètre de contrainte pour la deuxième phase de génération.

9. Système d'émulation, destiné à émuler un circuit sous test associé à un environnement de test, comportant un banc de test matériel reconfigurable (BTR) capable d'émuler une partie au moins de l'environnement de test, ce banc de test étant connecté entre un ordinateur hôte et un émulateur matériel reconfigurable (EML), distinct du banc de test, et capable d'émuler au moins une partie du circuit sous test, des premiers moyens de génération aptes à générer un premier fichier de configuration de l'environnement de test, et des deuxièmes moyens de génération aptes à générer un deuxième fichier de configuration du circuit sous test, le banc de test reconfigurable comportant un générateur de signaux d'horloges, synchronisé par une horloge système de base et délivrant différents signaux d'horloge secondaires synchronisant l'émulateur du circuit sous test et certains au moins des moyens matériels du banc de test, ainsi que des moyens de rétrocontrôle d'horloge capable en réponse à au moins un signal d'attente émis par l'un des moyens matériels du banc de test cadencé par un premier signal d'horloge secondaire, d'inhiber temporairement certains des autres signaux d'horloge secondaires de fréquences différentes de celle du premier signal d'horloge secondaire.

10. Système selon la revendication 9, **caractérisé par le fait que** le banc de test reconfigurable (BTR) comporte une partie dite fixe et au moins un circuit reconfigurable d'interface (CRFG) capable de réaliser la partie émulée de l'environnement de test.

11. Système selon la revendication 10, **caractérisé par le fait que** la partie fixe comporte au moins un circuit de contrôle (CCTL) et un circuit d'interface (CIBS) avec l'ordinateur hôte, et **par le fait que** le circuit reconfigurable d'interface est apte à comporter au moins des interfaces de pilotes/moniteurs de stimulation logicielle capables d'établir une communication avec au moins un processus logiciel exécuté sur l'ordinateur hôte, et des pilotes/moniteurs de stimulation matérielle émulée.

12. Système selon la revendication 11, **caractérisé par le fait que** la partie fixe comporte en outre des pilotes/moniteurs matériels réels supplémentaires, et **par le fait que** le circuit reconfigurable (CRFG) est apte à comporter en outre des interfaces avec ces pilotes/moniteurs matériels réels supplémentaires.

13. Système selon l'une des revendications 9 à 12, **caractérisé par le fait que** la partie fixe comporte en outre un circuit d'interface (IFSC) avec un dispositif cible (SYC).

14. Système selon l'une des revendications 9 à 13, **caractérisé par le fait que** la partie fixe comporte en outre la partie contrôle d'un analyseur logique matériel (AL) dont l'état évolue en fonction de déclencheurs matériels.

15. Système selon l'une des revendications 9 à 14, **caractérisé par le fait que** le banc de test et l'émulateur sont réalisés sur une carte électronique externe à l'ordinateur hôte et connectée à la carte mère de celui-ci.

16. Système selon l'une des revendications 9 à 14, **caractérisé par le fait que** le banc de test reconfigurable est réalisé sur une première carte électronique externe à l'ordinateur hôte et connectée à la carte mère de celui-ci, et **par le fait que** l'émulateur du circuit sous test est réalisé sur une ou plusieurs autres cartes externes à l'ordinateur hôte connectées à ladite première carte externe.

17. Système selon la revendication 16, **caractérisé par le fait que** le circuit d'interface avec le dispositif cible est intégré à ladite première carte externe.

18. Système selon l'une des revendications 10 à 15, **caractérisé par le fait que** le banc de test et l'émulateur sont réalisés sur une carte électronique interne (CINT) incorporée dans l'ordinateur hôte.

19. Système selon les revendications 13 et 18, **caractérisé par le fait que** le circuit d'interface avec le dispositif cible est réalisé sur une carte électronique externe (CXT) à l'ordinateur hôte, et apte à être connectée à ladite carte électronique interne (CINT).

20. Carte électronique, destinée à être connectée à la carte mère d'un ordinateur hôte, comportant un banc de test matériel reconfigurable (BTR) capable d'émuler une partie au moins d'un environnement de test associé à un circuit sous test, et un émulateur matériel reconfigurable (EML), distinct du banc de test, connecté au banc de test reconfigurable et capable d'émuler au moins une partie du circuit sous test, le banc de test reconfigurable comportant un générateur de signaux d'horloges, synchronisé par une horloge système de base et délivrant différents signaux d'horloge secondaires de fréquences différentes, ainsi que des moyens de rétrocontrôle d'horloge capable en réponse à un signal d'attente émis par l'un des moyens matériels du banc de test cadencé par un premier signal d'horloge secondaire, d'inhiber temporairement les signaux d'horloge secondaires de fréquences différentes de celle du premier signal d'horloge secondaire.

21. Carte selon la revendication 20, **caractérisée par le fait que** le banc de test reconfigurable (BTR) comporte une partie dite fixe et au moins un circuit reconfigurable capable de réaliser la partie émulée de l'environnement de test.

22. Carte selon la revendication 21, **caractérisée par le fait que** la partie fixe comporte au moins un circuit de contrôle (CCTL) et un circuit d'interface avec l'ordinateur hôte, et **par le fait que** le circuit reconfigurable est apte à comporter au moins des interfaces de pilotes/moniteurs de stimulation logicielle capables d'établir une communication avec au moins un processus logiciel exécuté sur l'ordinateur hôte, et des pilotes/moniteurs de stimulation matérielle émulée.

23. Carte selon la revendication 22, **caractérisée par le fait que** la partie fixe comporte en outre des pilotes/moniteurs matériels réels supplémentaires, et **par le fait que** le circuit reconfigurable est apte à comporter en outre des interfaces avec ces pilotes/moniteurs matériels réels supplémentaires.

## Patentansprüche

1. Verfahren zum Emulieren einer getesteten Schaltung, die einer Testumgebung zugeordnet ist, das umfasst: zwei verschiedene Erzeugungsphasen, die eine erste Phase (80) zum Erzeugen einer ersten Datei (FCH1) zur Konfiguration der Testumgebung und eine zweite Phase (81) zum Erzeugen einer zweiten Datei (FCH2) zur Konfiguration wenigstens eines Teils der getesteten Schaltung enthalten, die Ausgabe der ersten Konfigurationsdatei an einen ersten neu konfigurierbaren Hardware-Teil (BTR), der eine neu konfigurierbare Testbank bildet, derart, dass die Testbank konfiguriert wird, und die Ausgabe der zweiten Konfigurationsdatei an einen zweiten neu konfigurierbaren Hardware-Teil (EML), derart, dass ein Emulator der getesteten Schaltung konfiguriert wird, wobei die zwei Hardware-Teile voneinander verschieden und miteinander verbunden sind, wobei die neu konfigurierbare Testbank umfasst: einen Taktsignalgenerator, der durch einen Basis-Systemtakt synchronisiert ist und verschiedene sekundäre Taktsignale ausgibt, die den Emulator der getesteten Schaltung und wenigstens bestimmte der Hardware-Mittel der Testbank synchronisieren, sowie Taktrücksteuerungsmittel, die in Reaktion auf wenigstens ein Wartesignal, das von einem der Hardware-Mittel der Testbank, das durch ein erstes sekundäres Taktsignal getaktet wird, ausgesendet wird, vorübergehend bestimmte andere sekundäre Taktsignale mit Frequenzen, die von jener des ersten sekundären Taktsignals verschieden sind, sperren.

2. Verfahren nach Anspruch 1, **dadurch gekennzeichnet, dass** die erste Erzeugungsphase (80) die Erzeugung (800) einer Logikschaltung (CRL), die durch einen Netz von Logikgattern gebildet ist und die Testumgebung sowie Kompilierungsrichtlinien repräsentiert, und eine Kompilierung (801) dieser Logikschaltung unter Berücksichtigung der Richtlinien, derart, dass die erste Konfigurationsdatei (FCH1) erhalten wird, umfasst.

3. Verfahren nach Anspruch 2, **dadurch gekennzeichnet, dass** die Testumgebung eine Gesamtheit von Treibern (PLi) und Monitoren (MNi) umfasst und dass die Erzeugung der Logikschaltung das Bilden von Hardware-Blöcken in Form von Netzen von Logikgattern umfasst, wobei diese Hardware-Blöcke Treiber/Monitor-Schnittstellen zur Software-Stimulation, Treiber/Monitor-Schnittstellen zur realen Hardware-Stimulation und Treiber/Monitoren zur emulierten Hardware-Stimulation, Rechenblöcke von Hardware-Triggern sowie einen Schnittstellenblock mit dem Emulator der getesteten Schaltung repräsentieren.

4. Verfahren nach Anspruch 3, **dadurch gekennzeichnet, dass** die Phase des Bildens der Hardware-Blöcke anhand von statisch definierten Gatter-Netzen oder von durch ein Software-Modul dynamisch generierten Gatter-Netzen erfolgt.

5. Verfahren nach einem der vorhergehenden Ansprüche, **dadurch gekennzeichnet, dass** die erste Erzeugungsphase (80) und die zweite Erzeugungsphase (81) parallel ausgeführt werden.

6. Verfahren nach einem der Ansprüche 1 bis 4, **dadurch gekennzeichnet, dass** die erste Erzeugungsphase (80) und die zweite Erzeugungsphase (81) sequenziell ausgeführt werden.

7. Verfahren nach Anspruch 6, **dadurch gekennzeichnet, dass** die erste Erzeugungsphase (80) vor oder nach der zweiten Erzeugungsphase (81) ausgeführt wird.

8. Verfahren nach den Ansprüchen 3 und 7, **dadurch gekennzeichnet, dass** dann, wenn die erste Erzeugungsphase nach der zweiten Erzeugungsphase ausgeführt wird, die Erzeugung der Logikschaltung (CRL) als Eingangsparameter eine Beschreibung der Zuweisung der logischen Eingänge/Ausgänge der getesteten Schaltung zu Anschlüssen des Emulators verwendet und dass dann, wenn die zweite Erzeugungsphase nach der ersten Erzeugungsphase ausgeführt wird, die Erzeugung der Logikschaltung als Eingangsparameter eine Beschreibung der Schnittstelle der getesteten Schaltung verwendet und am Ausgang eine Beschreibung der Zuweisung der logischen Eingänge/Ausgänge der getesteten Schaltung zu den Anschlüssen des Emulators liefert, wobei diese Ausgangsbeschreibung dann ein Zwangsbedingungsparameter für die zweite Erzeugungsphase ist.

9. Emulationssystem, das dazu bestimmt ist, eine getestete Schaltung, die einer Testumgebung zugeordnet ist, zu emulieren, und das Folgendes umfasst: eine neu konfigurierbare Hardware-Testbank (BTR), die wenigstens einen Teil der Testumgebung emulieren kann, wobei diese Testbank zwischen einen Host-Rechner und einen von der Testbank verschiedenen neu konfigurierbaren Hardware-Emulator (EML), der wenigstens einen Teil der getesteten Schaltung emulieren kann, geschaltet ist, erste Erzeugungsmittel, die eine erste Datei zur Konfiguration der Testumgebung erzeugen können, und zweite Erzeugungsmittel, die eine zweite Datei zur Konfiguration der getesteten Schaltung erzeugen können, wobei die neu konfigurierbare Testbank enthält: einen Taktsignalgenerator, der durch einen Basis-Systemtakt synchronisiert ist und verschiedene sekundäre Taktsignal ausgibt, die den Emulator der getesteten Schaltung und wenigstens bestimmte der Hardware-Mittel der Testbank synchronisieren, und Taktrücksteuerungsmittel, die in Reaktion auf wenigstens ein Wartesignal, das von einem der Hardware-Mittel der Testbank ausgesendet wird, das durch ein erstes sekundäres Taktsignal getaktet wird, vorübergehend bestimmte andere sekundäre Taktsignale mit Frequenzen, die von jener des ersten sekundären Taktsignals verschieden sind, sperren.

10. System nach Anspruch 9, **dadurch gekennzeichnet, dass** die neu konfigurierbare Testbank (BTR) einen sogenannten festen Teil und wenigstens eine neu konfigurierbare Schnittstellenschaltung (CRFG), die den emulierten Teil der Testumgebung verwirklichen kann, umfasst.

11. System nach Anspruch 10, **dadurch gekennzeichnet, dass** der feste Teil wenigstens eine Steuerschaltung (CCTL) und eine Schnittstellenschaltung (CIBS) mit dem Host-Rechner umfasst und dass die neu konfigurierbare Schnittstellenschaltung wenigstens Treiber/Monitor-Schnittstellen zur Software-Stimulation, die eine Kommunikation mit wenigstens einem Software-Prozess, der in dem Hast-Rechner ausgeführt wird, aufbauen können, und Treiber/Monitore zur emulierten Hardware-Stimulation umfassen kann.

12. System nach Anspruch 11, **dadurch gekennzeichnet, dass** der feste Teil außerdem zusätzliche reale Hardware-Treiber/Monitore umfasst und dass die neu konfigurierbare Schaltung (CRFG) außerdem Schnittstellen mit diesen zusätzlichen realen Hardware-Treibern/Monitoren umfassen kann.

13. System nach einem der Ansprüche 9 bis 12, **dadurch gekennzeichnet, dass** der feste Teil außerdem eine Schnittstellenschaltung (IFSC) mit einer Zielvorrichtung (SYC) umfasst.

14. System nach einem der Ansprüche 9 bis 13, **dadurch gekennzeichnet, dass** der feste Teil außerdem den Steuerteil eines Hardware-Logikanalysators (AL), dessen Zustand sich als Funktion von Hardware-Triggern entwickelt, umfasst.

15. System nach einem der Ansprüche 9 bis 14, **dadurch gekennzeichnet, dass** die Testbank und der Emulator auf einer elektronischen Karte außerhalb des Host-Rechners verwirklicht sind, die mit dessen Hauptplatine verbunden ist.

16. System nach einem der Ansprüche 9 bis 14, **dadurch gekennzeichnet, dass** die neu konfigurierbare Testbank auf einer ersten elektronischen Karte außerhalb des Host-Rechners verwirklicht ist, die mit dessen Hauptplatine verbunden ist, und dass der Emulator der getesteten Schaltung auf einer oder mehreren anderen Karten außerhalb des Host-Rechners, die mit der ersten externen Karte verbunden sind, verwirklicht ist.

17. System nach Anspruch 16, **dadurch gekennzeichnet, dass** die Schnittstellenschaltung mit der Zielvorrichtung in die erste externe Karte integriert ist.

18. System nach einem der Ansprüche 10 bis 15, **dadurch gekennzeichnet, dass** die Testbank und der Emulator auf einer internen elektronischen Karte (CINT), die in den Host-Rechner eingebaut ist, verwirklicht sind.

19. System nach den Ansprüchen 13 und 18, **dadurch gekennzeichnet, dass** die Schnittstellenschaltung mit der Zielvorrichtung auf einer elektronischen Karte (CXT) außerhalb des Host-Rechners verwirklicht ist und mit der internen elektronischen Karte (CINT) verbunden sein kann.

20. Elektronische Karte, die dazu bestimmt ist, mit der Hauptplatine eines Host-Rechners verbunden zu werden, und die Folgendes umfasst: eine neu konfigurierbare Hardware-Testbank (BTR), die wenigstens einen Teil einer Testumgebung emulieren kann, der eine getestete Schaltung zugeordnet ist, und einen neu konfigurierbaren Hardware-Emulator (EML), der von der Testbank verschieden ist, mit der neu konfigurierbaren Testbank verbunden ist und wenigstens einen Teil der getesteten Schaltung emulieren kann, wobei die neu konfigurierbare Testbank Folgendes enthält: einen Taktsignalgenerator, der durch einen Basis-Systemtakt synchronisiert ist und verschiedene sekundäre Taktsignale mit verschiedenen Frequenzen ausgibt, und Taktrücksteuerungsmittel, die in Reaktion auf ein Wartesignal, das durch eines der Hardware-Mittel der Testbank ausgegeben wird, das durch ein erstes sekundäres Taktsignal getaktet ist, vorübergehend die sekundären Taktsignale mit Frequenzen, die von jener des ersten sekundären Taktsignals verschieden sind, sperren.

21. Karte nach Anspruch 20, **dadurch gekennzeichnet, dass** die neu konfigurierbare Testbank (BTR) einen festen Teil und wenigstens eine neu konfigurierbare Schaltung, die den emulierten Teil der Testumgebung verwirklichen kann, umfasst.

22. Karte nach Anspruch 21, **dadurch gekennzeichnet, dass** der feste Teil wenigstens eine Steuerschaltung (CCTL) und eine Schnittstellenschaltung mit dem Host-Rechner umfasst und dass die neu konfigurierbare Schaltung wenigstens Treiber/Monitor-Schnittstellen zur Software-Stimulation, die eine Kommunikation mit wenigstens einem Software-Prozess, der auf dem Host-Rechner ausgeführt wird, aufbauen können, und Treiber/Monitore zur emulierten Hardware-Stimulation umfassen kann.

23. Karte nach Anspruch 22, **dadurch gekennzeichnet, dass** der feste Teil außerdem zusätzliche reale Hardware-Treiber/Monitore umfasst und dass die neu konfigurierbare Schaltung außerdem Schnittstellen mit diesen zusätzlichen realen Hardware-Treibern/Monitoren umfassen kann.

## Claims

1. Method of emulating a circuit under test associated with a test environment, comprising two distinct generating phases comprising a first phase of generating (80) a first file (FCH1) for configuring the test environment, and a second phase of generating (81) a second file (FCH2) for configuring at least a part of the circuit under test, the delivery of the first configuration file to a first reconfigurable hardware part (BTR) forming a reconfigurable test bench so as to configure the test bench, and the delivery of the second configuration file to a second reconfigurable hardware part (EML) so as to configure an emulator of the circuit under test, the two hardware parts being distinct and mutually connected, the reconfigurable test bench comprising a clock signals generator synchronized by a base system clock and delivering various secondary clock signals synchronizing the emulator of the circuit under test and certain at least of the hardware means of the test bench, as well as clock retrocontrol means capable in response to at least one wait signal transmitted by one of the hardware means of the test bench regulated by a first secondary clock signal of temporarily disabling certain of the other secondary clock signals with different frequencies from that of the first secondary clock signal.

2. Method according to Claim 1, **characterized in that** the first generating phase (80) comprises the production (800) of a logic circuit (CRL) consisting of a network of logic gates and representative of the test environment as well as of the compilation directives, and a compilation (801) of this logic circuit having regard to the said directives, so as to obtain the first configuration file (FCH1).

3. Method according to Claim 2, **characterized in that** the test environment comprises a collection of drivers (PLi) and of monitors (MNi), and **in that** the production of the said logic circuit comprises the formation of hardware blocks in the form of networks of logic gates, these hardware blocks representing interfaces of drivers/monitors of software stimulation, interfaces of drivers/monitors of real hardware stimulation, and drivers/monitors of emulated hardware stimulation, blocks for calculations of hardware triggers, as well as a block for interfacing with the emulator of the circuit under test.

4. Method according to Claim 3, **characterized in that** the phase of forming the hardware blocks is effected on the basis of statically defined networks of gates or of networks of gates which are generated dynamically by a software module.

5. Method according to one of the preceding claims, **characterized in that** the first generating phase (80) and the second generating phase (81) are performed in parallel.

6. Method according to one of Claims 1 to 4, **characterized in that** the first generating phase (80) and the second generating phase (81) are performed sequentially.

7. Method according to Claim 6, **characterized in that** the first generating phase (80) is performed before or after the second generating phase (81).

8. Method according to Claims 3 and 7, **characterized in that** when the first generating phase is performed after the second generating phase, the production of the logic circuit (CRL) uses as input parameters a description of the assignment of the logic inputs/outputs of the circuit under test to the pins of the emulator, and **in that** when the second generating phase is performed after the first generating phase, the production of the logic circuit uses as input parameters a description of the interface of the circuit under test and supplies as output a description of the assignment of the logic inputs/outputs of the circuit under test to the pins of the emulator, this output description then being a constraint parameter for the second generating phase.

9. Emulation system, intended to emulate a circuit under test associated with a test environment, comprising a reconfigurable hardware test bench (BTR) capable of emulating a part at least of the test environment, this test bench being connected between a host computer and a reconfigurable hardware emulator (EML), distinct from the test bench, and capable of emulating at least a part of the circuit under test, first generating means able to generate a first file for configuring the test environment, and second generating means able to generate a second file for configuring the circuit under test, the reconfigurable test bench comprising a clock signals generator synchronized by a base system clock and delivering various secondary clock signals synchronizing the emulator of the circuit under test and certain at least of the hardware means of the test bench, as well as clock retrocontrol means capable in response to at least one wait signal transmitted by one of the hardware means of the test bench regulated by a first secondary clock signal of temporarily disabling certain of the other secondary clock signals with different frequencies from that of the first secondary clock signal.

10. System according to Claim 9, **characterized in that** the reconfigurable test bench (BTR) comprises a so-called fixed part and at least one reconfigurable interface circuit (CRFG) capable of embodying the emulated part of the test environment.

11. System according to Claim 10, **characterized in that** the fixed part comprises at least one control circuit (CCTL) and one circuit (CIBS) for interfacing with the host computer, and **in that** the reconfigurable interface circuit is able to comprise at least interfaces of drivers/monitors of software stimulation which are capable of establishing a communication with at least one software process executed on the host computer, and drivers/monitors of emulated hardware stimulation.

12. System according to Claim 11, **characterized in that** the fixed part furthermore comprises additional real hardware drivers/monitors, and **in that** the reconfigurable circuit (CRFG) is able furthermore to comprise interfaces with these additional real hardware drivers/monitors.

13. System according to one of Claims 9 to 12, **characterized in that** the fixed part furthermore comprises a circuit (TISC) for interfacing with a target device (SYC).

14. System according to one of Claims 9 to 13, **characterized in that** the fixed part furthermore comprises the control part of a hardware logic analyser (AL) whose state evolves as a function of the hardware triggers,

15. System according to one of Claims 9 to 14, **characterized in that** the test bench and the emulator are embodied on an electronic card external to the host computer and connected to the latter's mother card.

16. System according to one of Claims 9 to 14 **characterized in that** the reconfigurable test bench is embodied on a first electronic card external to the host computer and connected to the latter's mother card, and **in that** the emulator of the circuit under test is embodied on one or more other cards external to the host computer and connected to the said first external card.

17. System according to Claim 16, **characterized in that** the circuit for interfacing with the target device is integrated into the said first external card.

18. System according to one of Claims 10 to 15, **characterized in that** the test bench and the emulator are embodied on an internal electronic card (CINT) incorporated into the host computer.

19. System according to Claims 13 and 18, **characterized in that** the circuit for interfacing with the target device is embodied on an external electronic card (CXT) outside the host computer, and able to be connected to the said internal electronic card (CINT).

20. Electronic card, intended to be connected to the mother card of a host computer, comprising a reconfigurable hardware test bench (BTR) capable of emulating a part at least of a test environment associated with a circuit under test, and a reconfigurable hardware emulator (EML), distinct from the test bench, connected to the reconfigurable test bench and capable of emulating at least a part of the circuit under test, the reconfigurable test bench comprising a clock signals generator synchronized by a base system clock and delivering various secondary clock signals of different frequencies, as well as clock retrocontrol means capable in response to a wait signal transmitted by one of the hardware means of the test bench regulated by a first secondary clock signal of temporarily disabling the secondary clock signals with different frequencies from that of the first secondary clock signal.

21. Card according to Claim 20, **characterized in that** the reconfigurable test bench (BTR) comprises a so-called fixed part and at least one reconfigurable circuit capable of embodying the emulated part of the test environment.

22. Card according to Claim 21, **characterized in that** the fixed part comprises at least one control circuit (CCTL) and one circuit for interfacing with the host computer, and **in that** the reconfigurable circuit is able to comprise at least interfaces of drivers/monitors of software stimulation which are capable of establishing a communication with at least one software process executed on the host computer, and drivers/monitors of emulated hardware stimulation.

23. Card according to Claim 22, **characterized in that** the fixed part furthermore comprises additional real hardware drivers/monitors, and **in that** the reconfigurable circuit is able to comprise further interfaces with these additional real hardware drivers/monitors.
